(19) Europäisches Patentamt / European Patent Office / Office européen des brevets

(11) **EP 4 203 076 A1**

(12) # DEMANDE DE BREVET EUROPEEN

(43) Date de publication:
**28.06.2023 Bulletin 2023/26**

(21) Numéro de dépôt: **22214663.1**

(22) Date de dépôt: **19.12.2022**

(51) Classification Internationale des Brevets (IPC):
**H01L 31/05** (2014.01)     **H01L 31/18** (2006.01)
**H01B 1/22** (2006.01)

(52) Classification Coopérative des Brevets (CPC):
**H01L 31/188; H01L 31/0512; H01L 31/1864**

(84) Etats contractants désignés:
**AL AT BE BG CH CY CZ DE DK EE ES FI FR GB
GR HR HU IE IS IT LI LT LU LV MC ME MK MT NL
NO PL PT RO RS SE SI SK SM TR**
Etats d'extension désignés:
**BA**
Etats de validation désignés:
**KH MA MD TN**

(30) Priorité: **21.12.2021 FR 2114151**

(71) Demandeur: **Commissariat à l'énergie atomique
et aux énergies alternatives
75015 Paris (FR)**

(72) Inventeurs:
• **BARTH, Vincent
38054 GRENOBLE CEDEX 09 (FR)**
• **VEIRMAN, Jordi
38054 GRENOBLE CEDEX 04 (FR)**

(74) Mandataire: **Cabinet Camus Lebkiri
25 rue de Maubeuge
75009 Paris (FR)**

(54) **PROCÉDÉS DE DURCISSEMENT D'UNE PÂTE CONDUCTRICE ET DE FABRICATION D'UNE CHAÎNE PHOTOVOLTAÏQUE ET ÉQUIPEMENT ASSOCIÉ**

(57) Un aspect de l'invention concerne un procédé de durcissement d'une portion de pâte conductrice (5) disposée sur une cellule photovoltaïque (4), la cellule photovoltaïque (4) comprenant une première face (4a) et une deuxième face (4b), la portion de pâte conductrice (5) étant disposée sur l'une des faces (4a, 4b) de la cellule photovoltaïque (4), le procédé de durcissement comprenant une première étape d'exposition (31), de la première face (4a) de la cellule photovoltaïque (4) à un premier rayonnement électromagnétique (310) comprenant au moins une composante comprise entre 300 nm et 700 nm.

[Fig.3]

**Description**

**DOMAINE TECHNIQUE DE L'INVENTION**

Le domaine technique de l'invention est celui du durcissement d'une pâte conductrice en vue d'interconnecter des cellules photovoltaïques de manière à former une chaîne photovoltaïque.

**ARRIÈRE-PLAN TECHNOLOGIQUE DE L'INVENTION**

La conversion d'un rayonnement électromagnétique en énergie électrique est réalisée par des cellules photovoltaïques dont une des faces au moins est illuminée par ledit rayonnement électromagnétique. Les cellules photovoltaïques peuvent être connectées entre elles et agencées les unes à côtés des autres de manière à former un ensemble compact appelé module photovoltaïque.

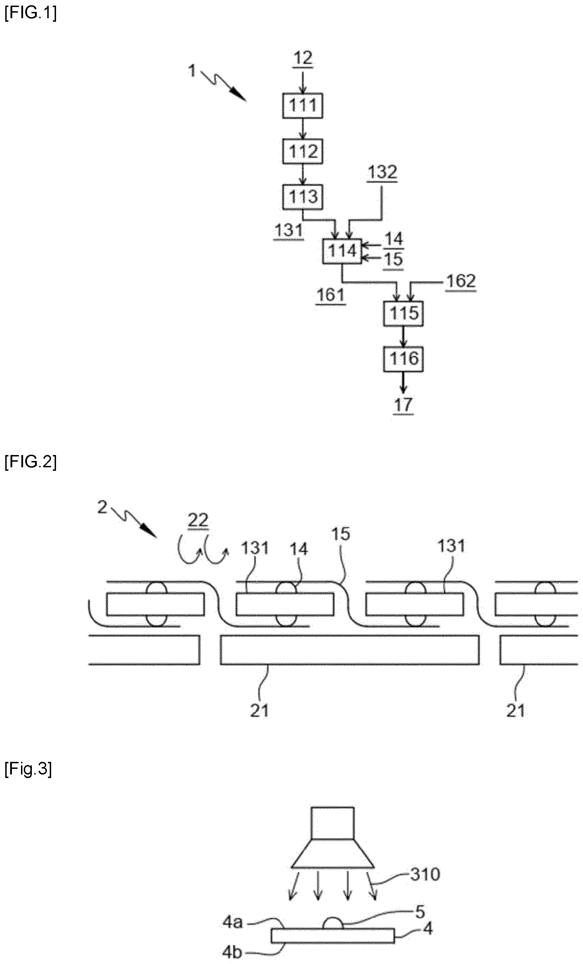

La FIG.1 représente schématiquement un exemple de procédé 1 de fabrication d'un module photovoltaïque 17 à partir d'un substrat semi-conducteur 12. Dans l'exemple illustré, il s'agit d'un substrat à hétérojonction de silicium.

Le procédé 1 comprend dans un premier temps une étape de nettoyage et de texturation 111 du substrat 12. S'en suit une étape 112 de dépôt d'une couche de silicium amorphe et d'oxyde transparent conducteur sur chaque face du substrat 12 de manière à les protéger.

Une étape de métallisation 113 permet de former les éléments conducteurs tels que des doigts de collecte et un busbar. À l'issue de l'étape de métallisation 113, le substrat 12 forme une première cellule photovoltaïque 131, prête à être connectée à un système électrique et à être exposée à un rayonnement.

Une étape d'interconnexion 114 permet de connecter électriquement en série la première cellule 131 avec une deuxième cellule 132 de manière à former une première chaîne photovoltaïque 161, également appelée guirlande photovoltaïque ou « *string* » en anglais. Une cellule forme une jonction de type PN dont une première face constitue une base et une deuxième face constitue un émetteur. La connexion des première et deuxième cellules 131, 132 en série permet de former un circuit électrique capable de générer un courant électrique sous une tension de quelques volts. Lorsque la première chaîne 161 compte jusqu'à soixante cellules en série, elle peut générer un courant électrique sous une tension comprise entre 35 V et 40 V.

L'interconnexion 114 des première et deuxième cellules 131, 132 comprend dans un premier temps le dépôt d'au moins une portion d'une pâte conductrice 14 sur une face de chaque cellule 131, 132. Afin de connecter les cellules 131, 132 en série, la pâte conductrice 14 est par exemple déposé sur l'émetteur de la première cellule 131 et sur la base de la deuxième cellule 132. L'interconnexion 114 comprend ensuite le dépôt d'un fil conducteur ou d'un ruban conducteur 15 de sorte que ce dernier s'appuie sur chaque portion de pâte conductrice 14 de chaque cellule 131, 132. Enfin, l'interconnexion 114 comprend le durcissement de la pâte conductrice 14, connectant électriquement et mécaniquement le ruban conducteur 15 à chaque cellule 131, 132.

La première chaîne 161 est avantageusement connectée à au moins une deuxième chaîne 162 lors d'une étape de mise en place 115 également appelée « *lay-up* » en anglais. Les première et deuxième chaînes 161, 162 sont disposées côte à côte de manière à former un ensemble compact de cellules photovoltaïques. Les chaînes 161, 162 sont ensuite connectées en série de manière à former un système électrique capable de générer une puissance électrique conséquente. Les chaînes 161, 162 ainsi connectées et agencées sont ensuite insérées dans une matrice transparente lors d'une étape de lamination 116 de manière à former un ensemble 17 électriquement connecté et mécaniquement rigide, appelé module photovoltaïque. Le module photovoltaïque 17 est un composant fini mis en oeuvre dans la production d'énergie électrique.

Un module photovoltaïque 17 peut montrer des problèmes de fiabilités électriques dues au la rupture de la conductivité électrique d'une chaîne dudit module. La coupure peut provenir d'un décollement d'un ruban conducteur d'une portion de pâte conductrice durcie ou un décollement de la portion de pâte conductrice durci d'une cellule.

La pâte conductrice mise en oeuvre pendant l'étape d'interconnexion 114 peut être un adhésif électriquement conducteur. On parle dans ce cas-là d'interconnexion par collage. Un adhésif électriquement conducteur comprend généralement un matériau organique à base d'époxy, d'acrylate ou d'un autre matériau capable de réticuler lors d'un traitement thermique de quelques secondes ou minutes dans la gamme de 150 °C à 250 °C. Ce matériau organique est chargé d'un matériau ayant des propriétés conductrices, comme des poudres métalliques, telles qu'une poudre d'argent, ou encore des charges métallisées en surface.

La pâte conductrice peut également être une pâte à souder. On parle dans ce cas-là d'interconnexion par soudage. Une pâte à souder comprend généralement une matrice chargée d'une poudre métallique capable de fusionner ou réaliser une transition vitreuse lors d'un traitement thermique de quelques secondes à quelques minutes à une température supérieure à 250 °C.

La [FIG.2] représente un exemple d'équipement 2 pour fabriquer une chaîne photovoltaïque, également appelé équipement d'interconnexion ou encore « *stringer* » en anglais, qui réalise le durcissement de la pâte conductrice 14 au moyen de plaques chauffantes 21 mises au contact des cellules 131, 132 pendant une durée donnée. Les plaques chauffantes 21 font par exemple partie d'un convoyeur supportant les cellules. Chaque cellule 131 se thermalise avec les plaques chauffantes 21 pour atteindre, au bout de quelques secondes ou quelques minutes, une température stationnaire, idéalement dans la gamme permettant le durcissement de la pâte conductrice 14. Toutefois, ce mode de thermalisation, mettant en oeuvre conduction thermique et convection thermique 22, crée un gradient thermique de part et d'autre de chaque cellule 131, 132. La différence de température entre la face en contact avec une plaque chauffante 21 et la face opposée, dite libre, peut atteindre plusieurs degrés, voire de plusieurs dizaines de degrés. De plus, la conductivité thermique des cellules ainsi que leur inertie thermique impliquent que la face libre chauffe moins rapidement que la face en contact avec une plaque chauffante. Le durcissement de la pâte conductrice 14 est donc réalisé différemment si elle est en contact avec la face libre ou avec la face directement chauffée et n'est donc pas optimal lorsque la pâte conductrice 14 est déposée sur une face libre.

De plus, les cellules réalisées à partir d'un substrat à hétérojonction de silicium présentent un budget thermique limité. En effet, à une température supérieure à 200 °C pendant plusieurs secondes, les couches formant une cellule à hétérojonction peuvent être endommagées. Il est donc préférable, même lors du durcissement de la pâte conductrice, de conserver une température maximale d'une cellule à hétérojonction inférieure à 200 °C. Or, dans ces conditions, la température de la face libre atteint difficilement la température de réticulation de l'adhésif, compromettant sa réticulation.

Il existe donc un besoin d'homogénéiser le durcissement de la pâte conductrice sur une cellule photovoltaïque.

## RÉSUMÉ DE L'INVENTION

Un premier aspect de l'invention résout les problèmes évoqués précédemment en permettant d'améliorer le durcissement de la pâte conductrice déposée sur une face d'une cellule photovoltaïque, quelle que soit cette face, afin de réduire finalement le risque de défaillance d'un module photovoltaïque en exploitation.

Pour cela, le premier aspect de l'invention concerne un procédé de durcissement d'une portion de pâte conductrice disposée sur une cellule photovoltaïque, la cellule photovoltaïque comprenant une première face et une deuxième face, opposée à la première face, la portion de pâte conductrice étant disposée sur l'une des première et deuxième faces de la cellule photovoltaïque, le procédé de durcissement comprenant une première étape d'exposition de la première face de la cellule photovoltaïque à un premier rayonnement électromagnétique comprenant au moins une composante comprise entre 300 nm et 700 nm.

Par composante ou raie, on entend par exemple une plage de fréquence restreinte autour d'une fréquence centrale, une irradiance spectrale étant supérieure à 0,04 W/m2/nm dans la plage de fréquence restreinte et inférieure à 0,04 W/m2/nm en dehors. Par plage de fréquence restreinte, on entend par exemple une plage de fréquence s'étendant sur moins de 10 nm.

Par une composante comprise entre deux bornes, on entend que la fréquence centrale de la plage de fréquence restreinte est comprise entre les deux bornes.

Grâce au premier rayonnement électromagnétique, le durcissement ne requiert pas de plaque chauffante. La composante s'étendant entre 300 nm et 700 nm est absorbée efficacement par la cellule photovoltaïque, réalisant un chauffage en volume de la cellule photovoltaïque. La thermalisation de la cellule photovoltaïque ne s'effectue plus d'une face vers l'autre mais du volume de la cellule photovoltaïque vers chaque face. Les première et deuxième faces de la cellule photovoltaïque présentent ainsi des températures sensiblement égales. Le durcissement de la pâte conductrice est donc réalisé de la même manière, quelle que soit la face sur laquelle elle est disposée.

Par température sensiblement égale, on entend par exemple égale à $\pm 5\%$.

De plus, la composante du premier rayonnement permet également de réaliser un traitement thermique de la cellule photovoltaïque qui améliore son rendement de conversion énergétique. En effet, la cellule photovoltaïque peut comporter une densité de défauts avant la première exposition, tels que des liaisons pendantes ou des ions métalliques, affectant de manière négative la conversion énergétique. Ces défauts favorisent la recombinaison des paires électron-trous, réduisant le courant électrique généré par la cellule photovoltaïque. En revanche, la cellule photovoltaïque voit son rendement de conversion énergétique amélioré de quelques pourcents sous l'action conjuguée d'un rayonnement électromagnétique et de la température. Ce phénomène dit de "bonification" ou « light soaking » en anglais, tend à minimiser les recombinaisons électrons-trous en réduisant la densité de défauts dans la cellule photovoltaïque.

Le procédé de durcissement selon le premier aspect de l'invention permet donc de bénéficier de deux effets avantageux par la mise en oeuvre d'un même rayonnement : réaliser le durcissement de la pâte conductrice et améliorer le rendement de conversion énergétique de la cellule photovoltaïque.

De préférence, ladite au moins une composante est comprise dans ]400 nm ; 700 nm]. Elle est par exemple comprise entre 410 nm et 700 nm.

De préférence, le premier rayonnement électromagnétique comprend une première composante comprise entre 300 nm et 550 nm et une deuxième composante comprise entre 700 nm et 1200 nm et de préférence entre 800 nm et 1100 nm.

Les très courtes longueurs d'onde, inférieures à 550 nm, sont très énergétiques et sont absorbées efficacement par la cellule photovoltaïque. Elles permettent donc d'améliorer la qualité de la cellule photovoltaïque au niveau de la première face avec une cinétique élevée. Les grandes longueurs d'onde, supérieures à 700 nm, sont absorbées moins efficacement par la cellule photovoltaïque mais sont absorbées sur toute l'épaisseur de la cellule photovoltaïque. Les grandes longueurs d'ondes permettent d'améliorer la qualité de la cellule photovoltaïque en volume et répartissent également le chauffage de la cellule photovoltaïque.

La superposition des première et deuxième composantes, dans deux gammes de longueurs d'onde séparées, permet donc d'obtenir un chauffage homogène de la cellule photovoltaïque et améliorer la cinétique de bonification de la cellule photovoltaïque.

Il est d'ailleurs d'autant plus avantageux que le premier rayonnement électromagnétique présente une irradiance spectrale entre 550 nm et 700 nm sensiblement nulle. Par sensiblement nulle ou négligeable, on entend par exemple une irradiance spectrale inférieure à 0,04 W/m$^2$/nm. Le rayonnement uniquement compris entre 550 nm et 700 nm est absorbé efficacement, réalisant un échauffement efficace de la cellule photovoltaïque. Toutefois, il est moins avantageux quant à la cinétique de bonification de la cellule photovoltaïque. Il est donc préférable pour réaliser un durcissement et une bonification à une cadence compatible avec les attentes industrielles que les plages considérées soient distinctes et strictement comprises entre 300 nm et 550 nm et entre 700 nm et 1200 nm.

Il est d'ailleurs plus avantageux, d'un point de vue de la cinétique de bonification, que les plages considérées soient comprises entre 300 nm et 500 nm et entre 800 nm et 1100 nm. Auquel cas le premier rayonnement électromagnétique peut également comprend une irradiance spectrale entre 700 nm et 800 nm et également sensiblement nulle, par exemple inférieure à 0,04 W/m$^2$/nm.

Par irradiance spectrale, on entend la puissance d'un rayonnement électromagnétique reçue par une unité de surface et par unité de longueur d'onde, cette unité de surface étant orientée perpendiculairement à la direction du rayonnement électromagnétique. L'unité de l'irradiance spectrale est le kW/m$^2$/nm.

Il est d'ailleurs avantageux que l'irradiance spectrale du premier rayonnement électromagnétique soit sensiblement nulle pour une longueur d'onde inférieure à 300 nm. En effet, les longueurs d'onde très courtes, inférieures à 300 nm, présentent un fort risque d'endommagement des couches de passivation, comprenant par exemple du silicium amorphe.

Il est également avantageux que l'irradiance spectrale du premier rayonnement électromagnétique soit sensiblement nulle pour une longueur d'onde supérieure à 1200 nm, voire supérieure à 1100 nm. En effet, pour les longueurs d'onde très longues, par exemple supérieures à 1100 nm, l'énergie n'est pas plus absorbée efficacement et ne permet pas de chauffer et/ou bonifier correctement la cellule photovoltaïque.

Afin de contrôler la puissance dissipée par les courtes longueurs d'onde et les grandes longueurs d'onde, le premier rayonnement électromagnétique comprend avantageusement :

- une première irradiance, dite irradiance UV, entre 300 nm et 550 nm ; et

- une deuxième irradiance, dite irradiance IR, entre 700 nm et 1200 nm et de préférence entre 800 nm et 1100 nm ;

le rapport de l'irradiance UV sur l'irradiance IR étant compris entre 10/90 et 50/50, par exemple égale à 30/70. La puissance dissipée par les grandes longueurs d'onde permet ainsi de chauffer efficacement la cellule photovoltaïque en volume sans que les courtes longueurs, très énergétiques, ne déséquilibrent ce chauffage en concentrant une trop grande partie de la puissance au voisinage de la première surface de cellule photovoltaïque. Ce rapport d'irradiances permet également d'assurer une cinétique de bonification équivalente à la cinétique de durcissement de la pâte conductrice.

Par irradiance ou éclairement énergétique ou encore densité surfacique de puissance lumineuse, on entend la puissance d'un rayonnement électromagnétique dans une plage de longueur d'onde, par exemple entre 300 nm et 550 nm ou entre 700 nm et 1200 nm, reçue par une unité de surface, cette unité de surface étant orientée perpendiculairement à la direction du rayonnement électromagnétique. En d'autres termes, il s'agit de l'intégration de l'irradiance spectrale sur l'une des plages de longueurs d'onde précitée.

Selon un premier mode de mise en oeuvre du procédé de durcissement, la première étape d'exposition présente une première durée d'exposition comprenant une première période, une deuxième période et une troisième période, séquentielles et consécutives. Le premier rayonnement électromagnétique présente dans ce cas :

- une première irradiance totale lors de la première période ;

- une deuxième irradiance totale lors de la deuxième période ; et

- une troisième irradiance totale lors de la troisième période.

Les première et deuxième irradiances totales sont avantageusement supérieures ou égales à la troisième irradiance totale.

Avantageusement, la durée de la première période est ajustée de sorte que la température de cellule photovoltaïque soit stabilisée à l'issue de la première période et la deuxième irradiance totale est supérieure à la première irradiance totale.

Avantageusement, la durée de la deuxième période est inférieure ou égale à 5 s, voire inférieure ou égale à 3 s, par exemple comprise entre 2 s et 3 s.

Selon le premier mode de mise en oeuvre, le procédé de durcissement peut comprendre une deuxième étape d'exposition de la première face à un deuxième rayonnement électromagnétique, la deuxième étape d'exposition étant réalisée avant la première étape d'exposition, le deuxième rayonnement électromagnétique présentant une quatrième irradiance totale, supérieure à la première irradiance totale et la deuxième étape d'exposition présentant une deuxième durée d'exposition inférieure à la première durée d'exposition.

La deuxième étape d'exposition permet d'améliorer davantage la bonification de la cellule photovoltaïque et le durcissement de la pâte conductrice. Elle permet par exemple de contrôler la montée en température de la cellule photovoltaïque en ajustant la deuxième irradiance totale et la deuxième durée d'exposition.

Le deuxième rayonnement électromagnétique comprend avantageusement au moins une composante comprise entre 300 nm et 700 nm.

De préférence, ladite au moins une composante est comprise dans ]400 nm ; 700 nm]. Elle est par exemple comprise entre 410 nm et 700 nm.

Par irradiance totale d'un rayonnement électromagnétique, on entend l'irradiance de ce rayonnement électromagnétique entre 300 nm et 700 nm, c'est à dire l'intégration de l'irradiance spectrale de ce rayonnement électromagnétique entre 300 nm et 700 nm.

Avantageusement, la deuxième étape d'exposition et la deuxième étape d'exposition sont espacées dans le temps. Permettant par exemple de stopper la montée en température de la cellule photovoltaïque et/ou de la portion de pâte conductrice traitée.

De manière avantageuse, l'intervalle de temps entre le début de la deuxième étape d'exposition et la fin de la première étape d'exposition est inférieur ou égal à 20 s. De cette manière, le procédé de durcissement est compatible avec les exigences de cadence industrielle même lorsqu'il met en oeuvre une étape d'exposition supplémentaire.

Avantageusement, le procédé de durcissement comprend une troisième étape d'exposition de la première face à un troisième rayonnement électromagnétique, la troisième étape d'exposition étant immédiatement consécutive à la première étape d'exposition, le troisième rayonnement électromagnétique présentant une cinquième irradiance totale décroissante en fonction du temps depuis la troisième irradiance totale.

Selon une première variante de mise en oeuvre, la pâte conductrice est un adhésif électriquement conducteur. Cette première variante s'applique d'ailleurs avantageusement à une cellule photovoltaïque à hétérojonction. En effet, la température de durcissement d'un adhésif électriquement conducteur est inférieure à 250 °C et est compatible avec une température maximale de 200 °C que peut supporter une cellule à hétérojonction. Le premier mode de mise en oeuvre s'applique également avantageusement à une cellule photovoltaïque comprenant une couche en pérovskites, dite "cellule photovoltaïque tandem".

De manière avantageuse, les première, deuxième et troisième irradiances totales et la première durée d'exposition sont choisies de sorte que la portion de pâte conductrice présente, à l'issue de la première exposition, une résistance à la rupture supérieure ou égale à 0,5 N/mm, la mesure de résistance à la rupture étant préférentiellement réalisée à une température de 180 °C. De la sorte, il est sûr que les paramètres d'exposition offrent un niveau de durcissement suffisant.

Selon un développement du premier mode de mise en oeuvre du procédé de durcissement, les première, deuxième et troisième irradiances totales et la première durée d'exposition sont choisies de sorte que la température de la cellule photovoltaïque soit comprise entre 150 °C et 250 °C pendant au moins 90° de la première durée d'exposition. Ainsi, le procédé permet de maintenir une cadence de production selon les attentes industrielles, tout en fournissant une portion de pâte conductrice correctement durcie.

Dans une deuxième variante de mise en oeuvre, la pâte conductrice est une pâte à souder. Cette deuxième variante s'applique aussi bien à une cellule photovoltaïque à homojonction qu'à hétérojonction. De plus, le soudage présente une meilleure résistance à la rupture.

Selon un développement du deuxième mode de mise en oeuvre du procédé de durcissement, les première, deuxième et troisième irradiances totales et la première durée d'exposition sont choisies de sorte que la portion de pâte conductrice présente, à l'issue de la première exposition, une résistance à la rupture supérieure à 1 N/mm, la mesure de résistance à la rupture étant préférentiellement réalisée à une température de 180 °C.

Ce niveau de durcissement de la pâte à souder peut être atteint en choisissant les première, deuxième et troisième irradiances totales et la première durée d'exposition de sorte que la température de la portion de pâte à souder soit comprise entre 180 °C et 270 °C pendant au moins 20 secondes.

Selon un développement de la deuxième variante, la deuxième irradiance totale est avantageusement supérieure au première et troisième irradiances totales, les première et troisième irradiances totales sont avantageusement choisies de sorte que la température de la cellule photovoltaïque soit comprise dans $[T_f - 5°C; T_f]$ pendant au moins 60% des première et troisième périodes et la deuxième irradiance totale est avantageusement choisie de sorte que la température de la cellule photovoltaïque soit supérieure ou égale à $T_f + 10°C$ pendant au moins 60% de la deuxième période.

La cellule photovoltaïque comprend avantageusement une base et un émetteur, l'émetteur est préférentiellement disposé au niveau de la première face. En effet, la cinétique de bonification est davantage améliorée lorsque l'émetteur est exposé au rayonnement.

Afin d'améliorer le contrôle de la température de la cellule photovoltaïque lors de la première étape d'exposition, elle peut également être chauffée lors de la première étape d'exposition, au moyen d'une source de chaleur distincte du premier rayonnement électromagnétique.

La bonification de la cellule photovoltaïque peut également être améliorée en recourant à un premier rayonnement présentant une irradiance totale élevée. Toutefois, l'irradiance totale élevée peut provoquer un échauffement trop important de la cellule photovoltaïque et peut provoquer un endommagement de ladite cellule. Il est donc avantageux que la cellule photovoltaïque soit refroidie lors de la première étape d'exposition. Ainsi, la température de la cellule photovoltaïque est contrôlée tout en permettant d'augmenter la cinétique de bonification de la cellule photovoltaïque.

Le procédé de durcissement selon le premier aspect est avantageusement mis en oeuvre lors de l'étape d'interconnexion d'une pluralité de cellules photovoltaïques pour former une chaîne photovoltaïque.

Un deuxième aspect de l'invention concerne d'ailleurs un procédé de fabrication d'une chaîne photovoltaïque à partir d'une première cellule photovoltaïque et d'une deuxième cellule photovoltaïque, chacune des première et deuxième cellules photovoltaïques comprenant une première face et une deuxième face, opposée à la première face, le procédé comprenant les étapes suivantes :

- déposer une première portion de pâte conductrice sur l'une des première et deuxième faces de la première cellule photovoltaïque ;

- interconnecter la deuxième cellule photovoltaïque à la première cellule photovoltaïque au moyen de la première portion de pâte conductrice ; et

- durcir la première portion de pâte conductrice au moyen d'un procédé de durcissement selon l'invention.

Le procédé de fabrication permet de fabriquer une chaîne photovoltaïque que l'on nommera "conventionnelle", dont les cellules photovoltaïques sont par exemple connectées au moyen d'un élément d'interconnexion, tel qu'un ruban ou un fil conducteur. Le procédé de fabrication permet également de fabriquer une chaîne photovoltaïque dite "en bardeau" ou « *shingle* » en anglais, dont les cellules sont superposées les unes aux autres à la manière de tuiles se recouvrant sur un toit.

Un premier mode de mise en oeuvre du procédé de fabrication adresse plus particulièrement la fabrication d'une chaîne photovoltaïque en bardeau. Selon ce premier mode de mise en oeuvre, la deuxième cellule photovoltaïque recouvre la première portion de pâte conductrice. La première portion de pâte conductrice est ainsi prise en sandwich entre les deux cellules photovoltaïques. La première exposition induit un échauffement dans le volume de chaque cellule photovoltaïque et chauffe la première portion de pâte conductrice de chaque côté, améliorant la reproductibilité de son durcissement.

Une deuxième mode de mise en oeuvre du procédé de fabrication adresse la fabrication d'une chaîne photovoltaïque conventionnelle. Selon ce deuxième mode de mise en oeuvre, une deuxième portion de pâte conductrice est disposée sur l'une des première et deuxième faces de la deuxième cellule photovoltaïque, la deuxième cellule photovoltaïque étant interconnectée à la première cellule au moyen d'un élément d'interconnexion connectant la première portion de pâte conductrice avec la deuxième portion de pâte conductrice, le procédé comprenant également une étape de durcissement de la deuxième portion de pâte conductrice au moyen du procédé de durcissement selon l'invention.

Par élément d'interconnexion, on entend par exemple un élément électriquement conducteur tel qu'un ruban métallique ou un fil métallique.

Un troisième aspect de l'invention concerne également un équipement pour fabriquer une chaîne photovoltaïque à partir d'une première cellule photovoltaïque et d'une deuxième cellule photovoltaïque, chacune des cellules photovoltaïques comprenant une première face et une deuxième face, opposée à la première face l'équipement comprenant :

- un applicateur configuré pour appliquer une première portion de pâte conductrice sur l'une des premières et deuxièmes faces de la première cellule photovoltaïque ;

- des moyens pour interconnecter la deuxième cellule photovoltaïque avec la première cellule photovoltaïque.

L'équipement est remarquable en ce qu'il comprend une source de rayonnement configurée pour exposer la première face de la première cellule photovoltaïque à un premier rayonnement électromagnétique comprenant au moins une première composante comprise entre 300 nm et 700 nm.

L'équipement permet ainsi de fabriquer une chaîne photovoltaïque plus fiable. En effet, il permet de réaliser le durcissement de la pâte conductrice selon le premier aspect de l'invention, garantissant un durcissement homogène, quelle que soit la face sur laquelle la pâte conductrice est déposée. Le risque de décollement de la pâte conductrice est donc réduit.

De plus, l'équipement est avantageux en ce qu'il peut être réalisé à partir d'un équipement de fabrication d'une chaîne photovoltaïque selon l'art antérieur. Il suffit pour cela d'ajouter une source de rayonnement pour obtenir un équipement selon le troisième aspect de l'invention, à même de fabriquer une chaîne photovoltaïque fiable.

L'équipement peut comprendre une sonde de température pour déterminer la température de la portion de pâte conductrice et/ou de la cellule photovoltaïque pendant l'exposition au premier rayonnement électromagnétique. La sonde permet ainsi de choisir l'irradiance totale du premier rayonnement électromagnétique et la première durée d'exposition de sorte que les conditions de durcissement soient optimales.

L'équipement peut également comprendre un banc d'essai pour déterminer la résistance à la rupture de la première portion de pâte conductrice. Le banc d'essai peut également être mis en oeuvre pour choisir l'irradiance totale du premier rayonnement électromagnétique et la première durée d'exposition de sorte que les conditions de durcissement soient optimales.

L'équipement peut aussi comprendre une source de chaleur distincte de la source de rayonnement.

Selon un développement, ladite au moins une première composante du premier rayonnement électromagnétique est comprise dans ]400 nm ; 700 nm]. Elle est par exemple comprise entre 410 nm et 700 nm.

L'invention et ses différentes applications seront mieux comprises à la lecture de la description qui suit et à l'examen des figures qui l'accompagnent.

**BRÈVE DESCRIPTION DES FIGURES**

Sauf précision contraire, un même élément apparaissant sur des figures différentes présente une référence unique. Les figures sont présentées à titre indicatif et nullement limitatif de l'invention.

[FIG.1] représente schématiquement un procédé de fabrication d'un module photovoltaïque selon l'art antérieur.

[FIG.2] représente schématiquement un équipement pour la fabrication d'une chaîne photovoltaïque selon l'art antérieur.

[FIG.3] représente schématiquement un premier mode de mise en oeuvre d'un procédé de durcissement d'une pâte conductrice selon un premier aspect de l'invention.

[FIG.4] représente schématiquement un premier exemple d'un premier rayonnement électromagnétique mis en oeuvre selon le procédé de la [FIG.3].

[FIG.5] représente schématiquement un deuxième exemple du premier rayonnement électromagnétique mis en oeuvre selon le procédé de la [FIG.3].

[FIG.6] représente schématiquement un deuxième mode de mise en oeuvre du procédé de durcissement d'une pâte conductrice selon le premier aspect de l'invention.

[FIG.7] représente schématiquement un troisième mode de mise en oeuvre du procédé de durcissement d'une pâte conductrice selon le premier aspect de l'invention.

[FIG.8] représente schématiquement un premier mode de mise en oeuvre d'un procédé de fabrication d'une chaîne photovoltaïque selon un deuxième aspect de l'invention.

[FIG.9] représente schématiquement un deuxième mode de mise en oeuvre du procédé de fabrication selon le deuxième aspect de l'invention.

[FIG.10] représente schématiquement un troisième mode de mise en oeuvre du procédé de fabrication selon le deuxième aspect de l'invention.

[FIG.11] représente schématiquement un quatrième mode de mise en oeuvre du procédé de fabrication selon le deuxième aspect de l'invention.

[FIG.12] représente schématiquement un cinquième mode de mise en oeuvre du procédé de fabrication selon le deuxième aspect de l'invention.

[FIG.13] représente schématiquement un exemple d'un équipement selon un troisième aspect de l'invention pour la fabrication d'une chaîne photovoltaïque.

## DESCRIPTION DÉTAILLÉE

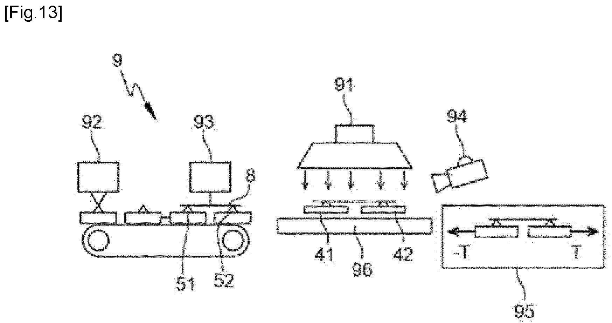

L'invention, selon ses différents aspects, va maintenant être décrite en référence aux [FIG.3] à [FIG.13].

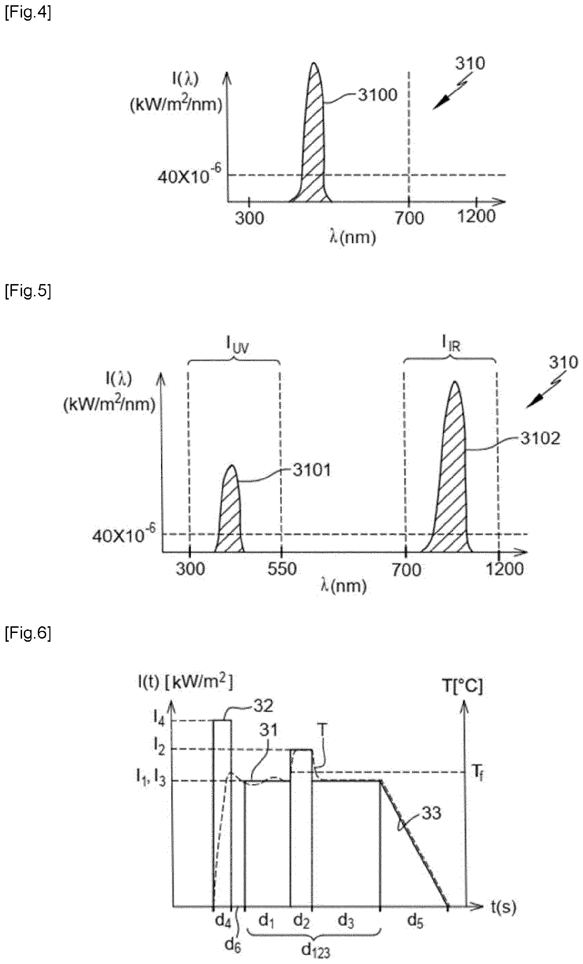

Les [FIG.3] et [FIG.4] représentent schématiquement un premier mode de mise en oeuvre d'un procédé de durcissement 3 d'une portion de pâte conductrice 5 disposée sur une cellule photovoltaïque 4.

Ledit procédé de durcissement 3 permet de réaliser le durcissement de la portion de pâte conductrice 5 de manière homogène, quel que soit la face sur laquelle ladite portion de pâte conductrice 5 est déposée.

La cellule photovoltaïque 4, que l'on appellera également simplement cellule, est par exemple à hétérojonction de silicium ou à homojonction de silicium.

La cellule 4, lorsqu'elle est à hétérojonction de silicium, comprend par exemple :

- un substrat en silicium cristallin dopé d'un premier type, par exemple de type n ;

- une couche de passivation en silicium amorphe hydrogéné intrinsèque, disposée sur chacune des faces du substrat ;

- un couche de silicium amorphe dopé, disposée sur chacune des couches de passivation ;

- une couche d'oxyde transparent conducteur ou TCO pour « *Transparent Conductive Oxyde* » en anglais, disposée sur chacune des couches de silicium amorphe dopé ;

- des métallisations, par exemple à base d'argent, disposées sur chaque couche d'oxyde transparent conducteur, formant par exemple des électrodes de collecte ou un agrégateur de courants, dit « *busbar* » en anglais.

La cellule 4 est par exemple obtenue par la mise en oeuvre des trois premières étapes 11, 12, 13 du procédé selon l'art antérieur de la [FIG.1]. La cellule 4 telle que présentée permet de générer un courant électrique lorsqu'elle est exposée à un rayonnement électromagnétique, par exemple le rayonnement solaire.

L'une des couches de silicium amorphe dopé est dopée du premier type, de type n dans l'exemple, et l'autre couche est dopée d'un deuxième type, différent du premier, de type p dans l'exemple. Une jonction, et en l'occurrence une hétérojonction ici, est formée par le substrat en silicium cristallin dopé du premier type et la couche de silicium amorphe dopée du deuxième type, cette couche formant un émetteur de la cellule 4. Le substrat en silicium cristallin dopé du premier type forme alors une base de la cellule 4.

Le substrat en silicium cristallin peut être dopé de type n ou de type p. Lorsque le substrat en silicium cristallin est dopé de type n, seules des impuretés dopantes de type donneur (par exemple des atomes de phosphore) ont été volontairement introduites dans le silicium cristallin du substrat afin de modifier sa conductivité électrique. Outre des impuretés dopantes de type donneur, le substrat peut contenir, de façon non intentionnelle (et donc à l'état de traces), des impuretés dopantes de type accepteur (telles que des atomes de bore). La concentration en impuretés dopantes de type accepteur Na, du substrat est avantageusement inférieure à $10^{13}$ cm$^{-3}$, de préférence inférieure à $3 \cdot 10^{12}$ cm$^{-3}$. La concentration en impuretés dopantes de type donneur $N_D$ est de préférence supérieure à 50 fois la concentration en impuretés dopantes de type accepteur $N_A$ (ou $N_D/N_A > 50$). De la même manière, lorsque le substrat en silicium cristallin est dopé de type p, seules des impuretés dopantes de type accepteur ont été volontairement introduites, telles que des atomes de bore, de gallium ou d'indium.

Chaque couche de passivation peut être en silicium amorphe hydrogéné, de préférence intrinsèque, c'est-à-dire non intentionnellement dopé. Le silicium amorphe hydrogéné intrinsèque permet en effet une meilleure passivation chimique des surfaces de silicium cristallin que le silicium amorphe hydrogéné dopé.

La couche en silicium amorphe dopé de type n est par exemple dopée par l'introduction d'impuretés de type donneur, telles que des atomes de phosphore. De la même manière que le substrat, outre des impuretés dopantes de type donneur, ladite couche en silicium amorphe dopé peut contenir, de façon non intentionnelle, des impuretés dopantes de type accepteur, à l'état de traces.

La cellule 4 comprend une première face 4a et une deuxième face 4b, opposée à la première face 4a. Chaque face de la cellule 4, lorsqu'elle est à hétérojonction, expose alors une couche de TCO et des métallisations.

La première face 4a de la cellule 4 est définie ici comme étant la face de la cellule 4 exposée à un rayonnement électromagnétique pour durcir une portion de pâte conductrice 5. L'émetteur de la cellule photovoltaïque 4 peut être disposé au niveau de la première face 4a ou de la deuxième face 4b de la cellule 4. En d'autres termes, la base ou l'émetteur de la cellule 4 peut être disposé au niveau de la première face 4a. La cellule 4 peut donc présenter sa base ou son émetteur audit rayonnement électromagnétique.

Une portion de pâte conductrice 5 est disposée sur l'une des première et deuxième faces 4a, 4b de la cellule 4. Dans l'exemple de la [FIG.3], il s'agit de la première face 4a. Par disposée sur une face, on entend que la portion de pâte conductrice est au contact de la face. Elle a par exemple été appliquée sur une partie de ladite face et présente un mouillage au moins partiel sur ladite face.

La pâte conductrice 5 est par exemple un adhésif électriquement conducteur dit ECA pour « Electrical Conductive Adhesive » en anglais. Un adhésif électriquement conducteur comprend par exemple un matériau capable de durcir lors d'un traitement thermique de quelques secondes. On peut d'ailleurs parler de thermo-réticulation ou de thermo-durcissement dans ce cas. Ledit matériau thermo-réticulable est par exemple un matériau organique à base de silicone, d'époxy et/ou d'acrylate. Le matériau thermo-réticulable est chargé d'un matériau conducteur électrique tel qu'une poudre de particules conductrice, par exemple des particules d'argent. La durée de la thermo-réticulation de l'adhésif électriquement conducteur peut dépendre de la température à laquelle il est exposé. Un abaque ou une loi reliant la durée de thermo-réticulation avec la température de l'adhésif électriquement conducteur peut par exemple être fournie par le fabricant de l'adhésif électriquement conducteur en question.

La durée de thermo-réticulation peut également être obtenue par la mise en oeuvre d'une mesure de calorimétrie différentielle à balayage ou DSC pour « Differential Scanning Calorimetry » en anglais. Une mesure de DSC permet de mesurer la température de transition, c'est à dire de réticulation, de l'adhésif, ainsi que l'enthalpie de réticulation, permettant de connaître le taux de réticulation de l'adhésif. Une mesure de DSC peut être complétée d'un calcul analytique ou de simulation numérique pour estimer la cinétique de réticulation.

Un adhésif électriquement conducteur est particulièrement adapté à une cellule 4 à hétérojonction de silicium car sa température de thermo-réticulation est inférieure à 250 °C, par exemple comprise entre 150 °C et 250 °C.

La pâte conductrice 5 peut être disposée en partie sur des métallisations de la cellule 4 afin de créer un bon contact électrique. Elle peut également être partiellement en contact avec l'oxyde transparent conducteur, notamment lorsqu'il s'agit d'un adhésif électriquement conducteur, car ces derniers montrent une meilleure adhérence sur ledit oxyde.

La pâte conductrice 5 peut également être une pâte à souder. Une pâte à souder comprend généralement une matrice chargée de particules métalliques et présente une température de fusion $T_f$. Elle est capable de fusionner ou réaliser une transition vitreuse lors d'un traitement thermique, par exemple un recuit, de quelques secondes à une température dépassant d'une dizaine de degrés au moins la température de fusion $T_f$. La pâte à souder comprend par exemple un alliage à base de bismuth tel que le SnBiAg, ou un alliage à base de plomb tel que les SnPb ou SnPbAg, ou encore un alliage sans plomb, par exemple à base d'étain, tel que les SnAg ou SnAgCu. Ces alliages présentent une température de fusion $T_f$ comprise entre 140 °C et 220 °C et fondent, au moins partiellement, lors d'un traitement thermique de quelques secondes à une température comprise entre 150 °C et 270 °C et de manière plus efficace entre à une température comprise entre 180 °C à 270°C. La température de traitement pour réaliser la fusion de la pâte 5 dépasse par exemple la température de fusion de l'alliage considéré d'au moins 10°C. De manière préféré, la température de traitement est supérieure ou égale à $T_f$ + 15°C, voire supérieure ou égale à $T_f$ + 25 °C.

La pâte conductrice 5, lorsqu'il s'agit d'une pâte à souder, est préférentiellement disposée sur des métallisations de la cellule 4 car elle montre une meilleure adhérence sur les parties métallisées.

Le procédé de durcissement 3 comprend une première étape d'exposition 31 de la première face 4a de la cellule photovoltaïque 4 à un premier rayonnement électromagnétique 310 comprenant au moins une composante 3100 comprise entre 300 nm et 700 nm.

La cellule 4 est par exemple placée sous une source de rayonnement électromagnétique 91 configurée pour émettre le premier rayonnement électromagnétique 310. Ladite source 91 est par exemple un ensemble de diodes électroluminescentes dites LED, ou une lampe au xénon filtrée pour laisser uniquement passer au moins la composante 3100. La première face 4a de la cellule 4 est alors orientée en direction de la source de rayonnement électromagnétique 91.

La [FIG.4] représente schématiquement un exemple de premier rayonnement électromagnétique 310 tel qu'il peut être mis en oeuvre par le procédé de durcissement 3. La figure représente une courbe d'irradiance spectrale $I(\lambda)$ du premier rayonnement 310 en fonction de la longueur d'onde $\lambda$, entre 300 nm et 700 nm. L'irradiance spectrale $I(\lambda)$ est donnée en kW/m$^2$/nm. Dans cet exemple, le premier rayonnement comprend une seule composante 3100 présentant une irradiance spectrale non nulle sur une plage restreinte entre 300 nm et 700 nm.

Au sens de l'invention une composante, que l'on appelle également raie, est une plage de fréquence restreinte autour d'une fréquence centrale, l'irradiance spectrale sur ladite plage restreinte étant non nulle, par exemple supérieure à 0,04 W/m2/nm. La plage de fréquence restreinte s'étend préférentiellement sur moins de 10 nm. La composante 3100 illustrée par la [FIG.4] n'est pas à l'échelle.

Le procédé de durcissement 3 permet ainsi de supprimer la nécessité de plaques chauffantes pour réaliser le chauffage de la cellule 4. Le chauffage de la cellule 4 est réalisée grâce au premier rayonnement électromagnétique 310 qui est absorbé par la cellule 4.

La composante 3100 comprise entre 300 nm et 700 nm est absorbée efficacement, notamment dans une cellule à hétérojonction de silicium. Le premier rayonnement 310 permet ainsi de chauffer efficacement la cellule 4. La montée en température de la cellule 4 pendant la première exposition 31 peut donc être rapide, permettant de rendre le procédé de durcissement 3 compatible avec une cadence industrielle.

L'énergie déposée dans la cellule 4 peut être concentrée au voisinage de la première face 4a de la cellule 4, exposée au premier rayonnement 310. Notamment, à une longueur d'onde de 300 nm, le premier rayonnement 310 est absorbé de manière substantielle sur quelques centaines de nanomètres, voir un micromètre. Toutefois, la composante 3100, même voisine des courtes longueurs d'onde (300 nm) apporte un intérêt par rapport à un chauffage au moyen d'une plaque chauffante. En effet, l'énergie est absorbée directement dans le volume de la cellule 4, même s'il est voisin de la première face 4a. La thermalisation par conduction est donc améliorée par rapport au chauffage par contact thermique avec une plaque chauffante. De plus, l'énergie est absorbée de manière homogène par la cellule 4, quel que soit la planéité ou la rugosité de la première face 4a, alors que le contact thermique de cette dernière avec une plaque chauffante peut être de moindre qualité, créant des points chauds et des points froids. La chaleur se propage donc de manière plus homogène dans la cellule 4 lorsqu'elle est issue du premier rayonnement électromagnétique 310.

De manière avantageuse, la composante 3100 du premier rayonnement électromagnétique 310 est comprise dans ]410 nm ; 700 nm], par exemple entre 410 nm et 700 nm. Cette gamme permet une bonne absorption de l'énergie et une absorption distribuée de manière homogène dans la cellule 4.

La composante 3100 voisine du centre de la gamme proposée, par exemple entre 550 nm et 700 nm, peut présenter un bon compromis entre une absorption efficace de l'énergie et une absorption homogène au sein de ladite cellule 4.

Le premier rayonnement électromagnétique présente un double intérêt en ce qu'il permet également de bonifier la cellule 4. Par bonification, on entend l'amélioration du rendement de conversion énergétique de la cellule 4. Le premier rayonnement électromagnétique 310 permet de réduire la densité de défauts dans la cellule 4, diminuant la densité de centres de recombinaison, préjudiciables à la conversion d'un rayonnement électromagnétique en courant électrique.

L'exposition au premier rayonnement améliore de manière significative la passivation de couches de silicium amorphes recouvrant un substrat en silicium cristallin. Elle améliore également la résistance en série entre les couches formant la cellule 4.

Plus la composante 3100 est voisine des courtes longueurs d'onde, c'est à dire 300 nm, est plus la bonification est rapide. En revanche, la bonification est majoritairement réalisée au voisinage de la première face 4a.

Plus la composante 3100 est voisine des grandes longueurs d'onde, c'est à dire de 700 nm, est moins la bonification est rapide. En revanche, le premier rayonnement 310 est absorbé de manière plus homogène selon l'épaisseur de la cellule 4, homogénéisant la bonification de la cellule 4 selon son épaisseur.

La composante 3100 comprise dans ]410 nm ; 700 nm] permet une bonification rapide au niveau de la première face 4a de la cellule tout en permettant une bonification homogène dans la cellule 4.

Une composante 3100 voisine, par exemple comprise entre 550 nm et 700 nm, offre un bon compromis entre une bonification rapide et homogène sur l'épaisseur de la cellule 4.

Le premier rayonnement 310 peut comprendre une pluralité de composantes, s'étendant entre 300 nm et 700 nm, chaque composante contribuant à l'homogénéisation et l'amélioration du durcissement de la pâte conductrice et également la bonification de la cellule 4. Selon un développement, le premier rayonnement 310 comprend une pluralité de composantes, s'étendant entre 410 nm et 700 nm.

La [FIG.5] représente d'ailleurs un autre exemple de premier rayonnement électromagnétique 310 tel qu'il peut être mis en oeuvre par le procédé de durcissement 3 et comprenant une pluralité de composantes. La [FIG.5] représente l'irradiance spectrale $I(\lambda)$ du premier rayonnement 310 en fonction de la longueur d'onde $\lambda$, entre 300 nm et 1200 nm. L'irradiance spectrale $I(\lambda)$ est également donnée en kW/m$^2$/nm.

Dans cet exemple, le premier rayonnement 310 comprend :

- une première composante appartenant à la plage de longueurs d'onde s'étendant entre 300 nm et 550 nm, ladite plage étant par exemple appelée plage ultraviolette ou abrégé « UV » ou encore appelée plage bleue ;

- une deuxième composante appartenant à la plage de longueurs d'onde s'étendant entre 700 nm et 1200 nm, ladite plage étant appelée plage infrarouge ou IR ; et

Les première et deuxième composantes 3101, 3102 appartiennent respectivement à des plages différentes, permettant de combiner les effets apportés par chaque plage. La première composante améliore la cinétique de bonification de la cellule 4, notamment au niveau de la première surface 4a, et chauffe efficacement la cellule 4. La deuxième composante, présentant une longueur d'onde comprise entre 700 nm et 1200 nm est absorbée selon toute l'épaisseur de la cellule. Elle bonifie donc la cellule 4 selon son épaisseur et homogénéise le chauffage de la cellule 4 selon son épaisseur. Ainsi, l'homogénéisation du durcissement de la pâte conductrice 5 et la bonification de la cellule 4 sont optimisées.

La deuxième composante est avantageusement comprise entre 800 nm et 1100 nm, permettant ainsi d'améliorer la bonification et le durcissement. En effet, l'absorption est plus élevée à 1100 nm qu'à 1200 nm. La deuxième composante est également absorbée de manière plus homogène à 800 nm qu'à 700 nm.

L'irradiance spectrale sur la plage entre 550 nm et 700 nm et préférentiellement entre 550 nm et 800 nm est avantageusement négligeable, voire nulle. On considère l'irradiance spectrale comme négligeable lorsqu'elle est inférieure à 0,04 W/m$^2$/nm, c'est à dire inférieure à 40·10$^{-6}$ kW/m$^2$/nm. Une troisième composante comprise entre 550 nm et 700 nm serait absorbé efficacement, permettant de réaliser un échauffement efficace de la cellule photovoltaïque. Toutefois, elle est moins avantageuse quant à la cinétique de bonification de la cellule photovoltaïque par rapport à la première composante, appartenant à la plage UV (aussi appelée plage bleue). Il est donc préférable, pour réaliser un durcissement et une bonification à une cadence compatible avec les exigences de production industrielle, de combiner les effets obtenus par des composantes appartenant aux plages UV et IR, plutôt que de choisir une seule composante appartenant à une plage intermédiaire.

On peut déterminer une première irradiance totale instantanée $I(t)$ du premier rayonnement 310, dont l'unité est le kW/m$^2$. La première irradiance totale instantanée $I(t)$ est égale à l'intégrale de l'irradiance spectrale du premier rayonnement 310 sur une gamme spectrale donnée, par exemple la gamme [300 ; 1200] nm. La première exposition 31, et donc le procédé de durcissement 3, est efficace lorsque la première irradiance totale instantanée $I(t)$ est par exemple supérieure ou égale à 1 kW/m$^2$. Elle est améliorée lorsque la première irradiance totale instantanée $I(t)$ est supérieure ou égale à 5 kW/m$^2$. Elle est par exemple comprise entre 1 kW/m$^2$ et 200 kW/m$^2$.

Selon une variante du présent exemple, le premier rayonnement 310 peut également présenter :

- une première irradiance $I_{UV}$, dite irradiance UV, déterminée sur la plage UV ; et

- une deuxième irradiance $I_{IR}$, dite irradiance IR, déterminée sur la plage IR.

Lorsque l'irradiance spectrale sur la troisième plage est négligeable, la première irradiance totale instantanée $I(t)$ est égale à la somme de l'irradiance UV et l'irradiance IR.

La première exposition 31 est améliorée lorsqu'un rapport de l'irradiance UV sur l'irradiance IR, c'est à dire $I_{UV}/I_{IR}$ , est avantageusement compris entre 10/90 et 50/50.

La [Fig.6] représente schématiquement la puissance totale instantanée I(t), (en kW/m$^2$) à laquelle la cellule 4 est exposée, en fonction du temps $t$ (en seconde). La [Fig.6] représente, en traits continus, la puissance totale instantanée $I$, dont l'ordonnée est sur la gauche. Elle représente également, en trait discontinu, un exemple de la température instantanée $T(t)$ de la cellule 4 en fonction du temps $t$.

Lors de la première étape d'exposition 31, se déroulant sur une durée $d_{123}$, la puissance totale instantanée $I(t)$ varie selon une série de périodes se déroulant de manière séquentielle et consécutive. La première étape 31 comprend ainsi une première période $d_1$, une deuxième période $d_2$ et une troisième période $d_3$. À chaque période $d_1$, $d_2$, $d_3$ est associée une irradiance totale instantanée, aussi appelée simplement appelée irradiance totale, lors de ladite période. Ainsi, lors de la première période $d_1$, le premier rayonnement 31 présente une première irradiance totale $I_1$. Lors de la deuxième période $d_2$, le premier rayonnement 31 présente une deuxième irradiance totale $I_2$. Et lors de la troisième période $d_3$, le troisième rayonnement 31 présente une troisième irradiance totale $I_3$.

Les première, deuxième et troisième irradiances $I_1$, $I_2$, $I_3$ peuvent présenter des valeurs différentes. Toutefois, le durcissement est amélioré lorsque les première et/ou deuxième irradiances totales $I_1$, $I_2$ sont supérieures ou égales à la troisième irradiance totale $I_3$. Dans l'exemple de la [Fig.6], la deuxième irradiance totale $I_2$ est supérieure aux première et troisième irradiances totales $I_1$, $I_3$, ces dernières étant égales. Cette configuration, où la deuxième irradiance totale $I_2$ est supérieure peut être appelée surexposition ou « overshoot » en anglais. La surexposition discutée plus bas, permet d'augmenter de manière temporaire la température de la cellule 4 de manière à, par exemple, accélérer le durcissement de la pâte ou encore faciliter l'adhésion de la portion de pâte lorsque celle-ci est une pâte à souder.

La [FIG.6] représente également un mode de mise en oeuvre dans lequel le procédé de durcissement 3 comprend une deuxième étape d'exposition 32 de la cellule 4. Il s'agit de l'exposition de la première face 4a à un deuxième rayonnement électromagnétique. La deuxième étape 32 permet d'amorcer le traitement thermique de la cellule 4 et de la portion de pâte conductrice 5. Elle peut être appelée étape de démarrage ou d'amorçage ou encore « ramp up » en anglais. La deuxième étape d'exposition 32 est réalisée avant la première étape d'exposition 31.

Les première et deuxième étapes d'exposition 31, 32 peuvent être séparées temporellement l'une de l'autre, la cellule 4 ne recevant aucun rayonnement électromagnétique visant à durcir la pâte conductrice ou bonifier ladite cellule 4 pendant une durée $d_6$. La durée $d_6$ est par exemple inférieure ou égale à 1 s.

Le deuxième rayonnement comprend, de la même manière que le premier rayonnement 310, au moins une composante comprise entre 300 nm et 700 nm. Il peut également présenter une ou plusieurs des caractéristiques additionnelles du premier rayonnement 310, telles que celles décrites en référence aux [FIG.4] et [FIG.5], en particulier une première composante comprise dans la plage UV et une deuxième composante comprise dans la plage IR. Le deuxième rayonnement diffère du premier rayonnement 310 en ce qu'il comprend :

- une quatrième irradiance totale $I_4$, différente de la première irradiance totale $I_1$; et

- une deuxième durée d'exposition $d_4$, différente de la première durée d'exposition $d_{123}$.

Dans la [FIG.6], la quatrième irradiance totale $I_4$ est supérieure à la première irradiance totale $I_1$. La quatrième irradiance totale $I_4$ est par exemple égale à 50 kW/m$^2$ alors que la première irradiance totale $I_1$ est égale à 10 kW/m$^2$. La deuxième durée d'exposition $d_4$ est inférieure à la première durée d'exposition $d_{123}$. La deuxième durée d'exposition $d_2$ est par exemple inférieure ou égale à 2 secondes alors que la première durée d'exposition $d_{123}$ est inférieure ou égale à 20 secondes.

La deuxième étape d'exposition 32 permet par exemple de réduire le temps de traitement complet en améliorant la montée en température de la cellule 4, permettant de réduire la première durée d'exposition $d_{123}$.

De manière avantageuse, l'intervalle de temps entre le début de la deuxième étape d'exposition 32 et la fine de la première étape d'exposition 31 est inférieur ou égal à 20 s. En d'autres termes, l'enchaînement des deux étapes est égal à :

$$d_{123} + d_6 + d_4 \leq 20\,s$$

Le deuxième rayonnement peut aussi comprendre, de la même manière que le premier rayonnement 310, au moins une composante comprise dans ]400 nm ; 700 nm], par exemple entre 410 nm et 700 nm.

Dans le mode de mise en oeuvre de la [FIG.6], le procédé de durcissement 3 comprend également une troisième étape d'exposition 33 de la première face 4a à un troisième rayonnement électromagnétique. La troisième étape d'exposition 33 est immédiatement consécutive à la première étape d'exposition 31. Elle assure notamment un refroidissement contrôlé de la cellule 4 en réduisant de manière contrôlée l'irradiance totale à laquelle est exposée la cellule 4. Pour cela, le troisième rayonnement électromagnétique présente une cinquième irradiance totale décroissante en fonction du temps, de préférence de manière monotone. Elle varie par exemple depuis la troisième irradiance totale $I_3$ jusqu'à une valeur nulle. La troisième étape exposition 33 présente préférentiellement une durée inférieure ou égale à 10 s. De la sorte, la durée totale du procédé peut être inférieure ou égale à 30 s et rester compatible avec une cadence industrielle. La troisième étape d'exposition 33 permet surtout de ralentir le refroidissement de la cellule 4 pour réduire les contraintes thermiques au sein de la cellule 4 et de la portion de pâte conductrice 5.

Le troisième rayonnement électromagnétique présente avantageusement les mêmes caractéristiques spectrales que le premier rayonnement électromagnétique 310. C'est à dire qu'il comprend au moins une composante comprise entre 300 nm et 700 nm. Selon un développement, il peut comprendre au moins une composante comprise dans ]400 nm : 700 nm], par exemple entre 410 nm et 700 nm.

Selon une variante, le procédé de durcissement 3 ne comprend pas la troisième étape d'exposition 33. Le refroidissement de la cellule 4 est alors rapide. Lorsque la pâte conductrice 5 est une pâte à souder, le refroidissement rapide permet de réaliser une trempe de la pâte à souder 5 lors de sa solidification. Le refroidissement rapide peut d'ailleurs être avantageusement accéléré par la mise en oeuvre d'une convection forcée, telle que résultante d'un jet de gaz dirigée vers la cellule 4.

Il est avantageux de caractériser une variation d'une propriété physicochimique de la pâte conductrice 5 pour déterminer si ladite pâte est suffisamment durcie ou non. Par exemple, ladite propriété physicochimique peut être une résistance à la rupture supérieure d'une portion de pâte conductrice 5 durcie. On peut, par exemple, considérer la pâte conductrice 5 comme suffisamment durcie lorsque sa résistance à la rupture, par exemple mesurée à une température de 180 °C, est supérieure ou égale à 0,5 N/mm. Ce niveau de résistance à la rupture est par exemple suffisant pour être mis en oeuvre dans un circuit photovoltaïque. Pour pouvoir comparer les mesures entre elles, la résistance à la rupture est indiquée par unité de largeur de la portion de pâte, selon une direction avantageusement perpendiculaire à la direction de traction exercée sur la pâte conductrice. Lorsqu'un fil ou un ruban d'interconnexion est collé ou soudé à la portion de pâte et qu'une traction est exercée sur le fil/ruban, la largeur considérée est par exemple la largeur du fil/ruban. L'unité est le N/mm.

La mesure ou la détermination de ladite propriété physicochimique permet également de dimensionner certaines caractéristiques du procédé de durcissement 3, par exemple liées à la première exposition 31. Il est par exemple avantageux de déterminer l'irradiance totale instantanée $I(t)$ en fonction du temps du premier rayonnement 310 et la première durée d'exposition $d_{123}$ au premier rayonnement 310 de sorte que la résistance à la rupture de la portion de pâte conductrice 5 soit supérieure ou égale à un seuil.

Les inventeurs ont réalisé des premiers essais, dont les principaux résultats sont regroupés dans le [Tableaux 1] ci-dessous, afin de déterminer l'efficacité du durcissement de la pâte conductrice lors de la mise en oeuvre du procédé de durcissement 3. Le protocole mis en oeuvre lors des essais permet par exemple de choisir les première, deuxième et troisième irradiances totales $I_1$, $I_2$, $I_3$ du premier rayonnement 310 et la première durée d'exposition $d_{123}$ au premier rayonnement 310 de sorte que la résistance à la rupture de la portion de pâte conductrice 5, mesurée à une température de 180 °C, soit supérieure ou égale à 0,5 N/mm.

Les premiers essais ont été réalisés sur sept premières cellules, indiquées 1 à 7 dans la colonne "CEL". Les essaies ont portés sur des cellules 4 à hétérojonction de silicium comprenant un substrat dopé de type n. La pâte conductrice 5 considérée était un adhésif électriquement conducteur Henkel Loctite 8282(TM), comprenant une base d'acrylate chargée de particules d'argent. La température de réticulation de l'adhésif est de 170°C. Une portion d'adhésif électriquement conducteur 5 a été déposée sur la première face 4a de chaque cellule 4, c'est à dire la face exposée au premier rayonnement 31. Un ruban métallique a été appliqué contre chaque première portion d'adhésif électriquement conducteur 5 de manière à pouvoir réaliser une mesure de résistance à la rupture de l'adhésif durci. Les mesures de résistance à la rupture ont été réalisée par l'application d'un effort de traction sur chaque ruban métallique après durcissement des portions d'adhésif, jusqu'à observation d'une rupture. Les valeurs de résistance à la rupture sont indiquées en N/mm dans la colonne "T". Les valeurs de résistance sont indiquées sous forme de gamme car le moyen de mesure mis en oeuvre présente un échantillonnage compris entre 0,1 N/mm et 0,2 N/mm.

Le type de rupture est également indiqué dans la colonne "Rupture", pouvant être de nature adhésive et cohésive. Par rupture adhésive, on entend que la rupture intervient entre la cellule et la portion d'adhésif durcie, la portion d'adhésif se détachant intégralement de la cellule. Par rupture cohésive, on entend que la rupture intervient dans la portion d'adhésif durcie, la portion d'adhésif se séparant en au moins deux parties, une partie restant attachée à la cellule et l'autre partie restant attachée au ruban. La rupture peut être de nature adhésive et cohésive lorsqu'une partie au moins de la portion d'adhésif se détache de la cellule et qu'une autre partie dudit adhésif se sépare en au moins deux.

L'adhésif étant disposé sur la première face 4a, il est également sur la face recevant le premier rayonnement 310. Les cellules 4 à hétérojonction ont été orientées (colonne "Orient.") en présentant leur base, indiqué "COL", ou leur émetteur, indiqué "EM". Ainsi, la base des cellules n°1, n°2, n°4 et n°5 a été exposé au premier rayonnement 310 tandis que l'émetteur des échantillons n°3, n°6 et n°7 a été exposé au premier rayonnement 310.

Le premier rayonnement électromagnétique présente une première composante, appartenant à la plage UV, centrée sur 455 nm et une deuxième composante, appartenant à la plage IR, centrée sur 940 nm. Le rapport des irradiances UV/IR du premier rayonnement 310, indiqué dans la colonne "$R_1$", est égal à 30/70 dans chaque cas. C'est à dire que l'irradiance UV constitue 30 % de l'irradiance totale du premier rayonnement 310 et l'irradiance IR constitue 70 % de l'irradiance totale du premier rayonnement 310. Les première, deuxième et troisième irradiances totales $I_1$, $I_2$, $I_3$ sont égales à une irradiance moyenne du premier rayonnement 310, indiqué dans la colonne "$I_{123}$", est de 10 kW/m$^2$ dans chaque cas. Une première durée d'exposition de chaque cellule 4 au premier rayonnement 310, indiquée dans la colonne "$d_{123}$", est de 180 secondes pour les trois premières cellules et 30 secondes pour les quatre suivantes.

Le temps d'attente entre l'application de la pâte conductrice 5 sur la cellule 4 et la première exposition 31 sont court, par exemple préférentiellement inférieur à une heure et avantageusement inférieur à une minute. Dans les essais, ledit temps était inférieur à 20 s.

Les résultats de résistance à la rupture sont compris entre 0,6 N/mm et 1,1 N/mm pour les sept cellules 4, quel que soit l'orientation de la cellule 4 ou la durée d'exposition.

La résistance à la rupture est comprise entre 0,9 N/mm et 1,1 N/mm pour les trois premières cellules 4, exposée 180 seconds au premier rayonnement 310, quelle que soit leur orientation. La rupture est de nature adhésive et cohésive. La résistance à la rupture et la nature de la rupture obtenue dans ces conditions opératoires sont équivalentes à des résultats mettant en oeuvre un procédé de durcissement selon l'art antérieur. En revanche, chaque cellule montre un gain en rendement compris entre 0,3 % et 0,4 % absolu, qu'il n'est pas possible d'obtenir avec un procédé de durcissement selon l'art antérieur.

La résistance à la rupture est comprise entre 0,6 N/mm et 0,8 N/mm lorsque les cellules 4 ont été exposée 30 secondes au premier rayonnement 310, quelle que soit l'orientation de la cellule 4. La nature de la rupture est en revanche principalement cohésive. La résistance à la rupture et la nature de la rupture obtenues dans ces conditions opératoires sont inférieures à des résultats mettant en oeuvre un procédé de durcissement selon l'art antérieur. Toutefois, ces résultats sont acceptables pour interconnecter deux cellules au sein d'une chaîne photovoltaïque ou pour la réalisation d'un module photovoltaïque. En revanche, la première durée d'exposition $d_{123}$ est inférieure à un temps de traitement selon l'art antérieur, permettant ainsi d'atteindre une cadence de production élevée, compatible avec les exigences industrielles. De plus, chaque cellule présente également un gain en rendement de conversion énergétique compris entre 0,2 % et 0,4 % absolu, impossible à obtenir avec un procédé selon l'art antérieur. Le gain de rendement est par exemple compris entre 0,2 % et 0,3 % absolu pour une durée de traitement de 30 s. Il est compris entre 0,3 % et 0,4 % absolu pour une durée de traitement de 180 s.

[Tableaux1]

| CEL | $R_1$ | $I_{123}$ | $d_{123}$ (s) | Orient. | T (N/mm) | Rupture |
|-----|-------|-----------|---------------|---------|----------|---------|
| 1 | 30/70 | 10 | 180 | COL | [0,9; 1,1] | C + A |
| 2 | 30/70 | 10 | 180 | COL | [0,9; 1,0] | C + A |
| 3 | 30/70 | 10 | 180 | EM | [0,9; 1,1] | C + A |
| 4 | 30/70 | 10 | 30 | COL | [0,7; 0,8] | C |
| 5 | 30/70 | 10 | 30 | COL | [0,6; 0,7] | A |
| 6 | 30/70 | 10 | 30 | EM | [0,6; 0,7] | C |
| 7 | 30/70 | 10 | 30 | EM | [0,5; 0,6] | A |

Ainsi, et tel que présenté dans le [Tableaux1], une première irradiance moyenne $I_{123}$ égale à 10 kW/m2 et une première durée d'exposition $d_{123}$ supérieure ou égale à 30 secondes permettent de durcir une portion de pâte conductrice 5 de sorte qu'elle présente une résistance à la rupture, à la fin de l'étape d'exposition 31, supérieure à 0,5 N/mm.

La pâte conductrice 5 durcie dès lors qu'elle subit un traitement thermique à une température dépassant une température minimale de durcissement, voire appartenant à une plage de températures.

Lorsque la pâte conductrice 5 est un adhésif électriquement conducteur, la plage de températures permettant le durcissement s'étend préférentiellement de 150 °C à 250 °C. Dès lors, la première irradiance moyenne $I_{123}$ et la première durée d'exposition $d_{123}$ peuvent être choisis de sorte que la première exposition 31 permette de chauffer la pâte conductrice 5 à une température comprise entre comprise entre 150 °C et 250 °C pendant au moins 20 secondes.

Une sonde de température 94, configurée pour mesurer la température de la portion de pâte conductrice 5 peut être mise en oeuvre pendant la première étape d'exposition. Elle peut permettre de déterminer l'irradiance totale instantanée $I(t)$ reçue par la cellule 4 et la première durée d'exposition $d_{123}$ nécessaire au durcissement de la portion de pâte 5. La sonde de température 94 peut mesurer la température de la portion de pâte conductrice 5 ou la température au voisinage de la portion de pâte conductrice 5. En effet, mesure la température du silicium à proximité de la portion de pâte conductrice 5 peut permettre de déterminer la température de la cellule 4 chauffée par le premier rayonnement 31 et donc de déterminer la température au niveau de la portion de pâte 5.

La sonde de température 94 peut être un moyen de mesure direct, tel qu'un thermocouple, ou un moyen de mesure sans contact, tel qu'une caméra thermique.

Les inventeurs ont réalisé des deuxièmes essais dans des conditions similaires aux premiers essais, afin de déterminer la température de la portion de pâte 5 en fonction de l'irradiance moyenne $I_{123}$ (sachant que $I_1 = I_2 = I_3 = I_{123}$) et de la première durée d'exposition $d_{123}$. Les principaux résultats sont regroupés dans le [Tableaux2] ci-dessous. Le rapport $I_{UV}/I_{IR}$ est notamment égale à 30/70.

Les deuxièmes essais diffèrent toutefois des premiers essais en ce que les cellules 4 testées présentent une épaisseur de 160 $\mu$m, standard au moment du dépôt de la présente demande. De plus, la température de la portion de pâte conductrice 5 a été mesurée au moyen d'un thermocouple type K en contact avec la cellule. Une caméra thermique peut également être utilisée.

Les résultats dans le [Tableaux2] montrent la température en degré Celsius obtenue lors d'essais complémentaires, en fonction de l'irradiance moyenne $I_{123}$ et de la première durée d'exposition $d_{123}$. Une température supérieure à 150 °C, permettant par exemple le durcissement de la pâte conductrice 5, est obtenue pour une irradiance moyenne $I_{123}$ supérieure ou égale à 8,5 kW/m$^2$ et une première durée d'exposition $d_{123}$ égale à 30 s. Une interpolation linéaire des résultats permet de déterminer qu'une irradiance moyenne $I_{123}$ supérieure ou égale à 7 kW/m$^2$ et une première durée d'exposition $d_{123}$ égale à 30 s permettent d'atteindre une température de 150 °C. Les valeurs données dans le tableau peuvent varier en fonction des propriétés de la cellule 4, notamment son épaisseur.

La température de la cellule 4 est mesurée au moyen d'un thermocouple disposé sur la surface 4a de la cellule 4 illuminée. Les températures et durées mesurées dépendent des échanges thermiques entre la cellule 4 et un environnement extérieur. Dans le cas présent la cellule 4 étant en suspension dans l'air ambient et à une température initiale ambiante. La cellule 4 atteint la température visée en environ 20 s. La cellule 4 pourrait bien évidemment être en contact avec une masse thermique régulée afin d'augmenter ou réduire la durée nécessaire pour chauffer la cellule 4.

[Tableaux2]

| T(°C) | $I_{123}$ (kW/m$^2$) | $d_{123}$ (S) |
|---|---|---|
| 120 | 4,3 | 30 |
| 140 | $\delta$ | 30 |
| 180 | 8,5 | 30 |
| 220 | 11,5 | 30 |

Selon un autre exemple, lorsque la pâte conductrice 5 est une pâte à souder, telle que décrite précédemment, elle présente une température de fusion $T_f$ pouvant être comprise entre 140 °C et 220 °C. Les première, deuxième et troisième irradiance totale $I_1, I_2, I_3$ et la première durée d'exposition $d_{123}$ (dont chacune des première, deuxième et troisième périodes $d_1, d_2, d_3$) sont préférentiellement choisies de sorte que la première étape d'exposition 31 permette de réaliser la fusion et la solidification de la pâte conductrice 5 et dans un même temps, réaliser la bonification de la cellule 4 sous-jacente.

Pour cela, le procédé de durcissement 3 prévoit, selon une mode de réalisation, de réaliser une première étape d'exposition 31 pendant laquelle la deuxième irradiance totale $I_2$ est supérieure au première et troisième irradiances totales $I_1, I_3$, ces dernières étant par exemple égales. Ce mode de fonctionnement est en partie illustré par la [Fig.6]. La première irradiance totale $I_1$ est notamment choisie de sorte que la température de la cellule photovoltaïque 4 soit inférieure à la température de fusion considérée et plus particulièrement comprise entre $T_f$ - 5°C et $T_f$ pendant une partie au moins de la première période $d_1$ de la première exposition 31 par exemple pendant au moins 60% de la première période $d_1$, voire pendant au moins 80 % de la première période $d_1$. Ainsi, lors de la première période $d_1$ la portion de pâte conductrice 5 est amenée à une température proche de sa température de fusion $T_f$. De plus, la durée de la première période $d_1$ permet d'attendre la stabilisation de la température au sein de la cellule 4 et de la portion de pâte à souder 5. Par stabiliser, on entend que la température de la cellule 4 varie de moins de 5 °C de sa température d'équilibre pendant au moins 50% de la première période $d_1$. Par température d'équilibre, on entend la température qu'aurait la cellule 4 au bout d'un temps d'attente très long, voire infini.

La deuxième irradiance totale $I_2$ est notamment choisie de sorte que la température de la cellule photovoltaïque 4 soit supérieure ou égale à $T_f$ + 10°C pendant au moins 60% de la deuxième période $d_2$, voire pendant au moins 80% de la deuxième période $d_2$. La deuxième période $d_2$ permet ainsi de réaliser la fusion de la pâte conductrice 5. La deuxième période $d_2$ est avantageusement courte, afin de limiter l'échauffement totale de la cellule 4 est limiter son budget thermique. La durée de la deuxième période $d_2$ est avantageusement inférieure ou égale à 5 s et de préférence inférieure ou égale à 3 s, par exemple comprise entre 2 s et 3 s.

À la suite de la deuxième période $d_2$, la troisième irradiance totale $I_3$ est choisie de sorte que la température de la cellule photovoltaïque 4 soit inférieure à la température de fusion considérée et plus particulièrement comprise entre $T_f$ - 5°C et $T_f$ pendant une partie au moins de la troisième période $d_3$ et préférentiellement pendant au moins 60% de la troisième période $d_3$, voire pendant au moins 80% de la troisième période $d_3$. Ainsi, la troisième période $d_3$ permet de réaliser le refroidissement et la solidification de la pâte conductrice 5. La température de la cellule 4 reste tout de même à une température proche de la température de fusion $T_f$ pendant la troisième période $d_3$ de sorte que les contraintes mécaniques dans la cellule 4 et/ou la portion de pâte conductrice 5 puisse s'équilibrer.

Les première et troisièmes périodes $d_1, d_3$ permettent également de maintenir une irradiance totale instantanée à un niveau qui soit élevée sans toutefois dépasser de manière non contrôlée à la température de fusion et compromettre le durcissement de la portion de pâte conductrice 5 sur la cellule 4. Puisque l'irradiance totale instantané est élevée, la cinétique de bonification est également élevée.

L'exemple de mise en oeuvre du procédé 3 est ici appliqué à une pâte à souder. Il trouve toutefois un intérêt lorsque la pâte conductrice 5 est un adhésif électriquement conducteur. On veillera toutefois à choisir les première, deuxième et troisième irradiances totales $I_1, I_2, I_3$ de sorte que la température de la cellule 4 soit maintenu dans une plage de température permettant la réticulation de l'adhésif pendant au moins 60 % de chaque période $d_1, d_2, d_3$. La deuxième irradiance $I_2$, supérieure au première et troisième irradiance $I_1, I_3$, permet d'accélérer la réticulation de l'adhésif tout en contrôlant le budget thermique de la cellule 4. Le procédé est compatible avec une cadence industrielle.

Afin de limiter l'impact sur le budget thermique de la cellule 4, il est avantageux de contrôler la température de ladite cellule, par exemple au moyen de la sonde de température. Les première, deuxième et troisième irradiances totales $I_1, I_2, I_3$ et les première, deuxième et troisième périodes d'exposition $d_1, d_2, d_3$ sont par exemple choisies de sorte que la température de la cellule 4 soit inférieure à 250 °C pendant la première étape d'exposition 31.

Les inventeurs ont réalisé des troisièmes essais, mettant en oeuvre une deuxième étape d'exposition 32. Les principaux résultats sont regroupés dans le [Tableaux3] ci-dessous. Les troisièmes essais ont été réalisés sur sept deuxièmes cellules, n°8 à n°14 dans la colonne "CEL". Les conditions opératoires des troisièmes essais sont similaires aux conditions opératoires des premiers essais.

Toutefois, à la différence des premiers essais, la base des cellules n°8, n°9, n°10 et n°11 a été exposée aux premier et deuxième rayonnements 310, tandis que l'émetteur des échantillons n°12, n°13 et n°14 a été exposé aux premier et deuxième rayonnements 310.

Le deuxième rayonnement électromagnétique présente également une première composante, appartenant à la plage UV, centrée sur 455 nm et une deuxième composante, appartenant à la plage IR, centrée sur 940 nm. Le rapport des irradiances UV/IR du premier rayonnement 310 et du deuxième rayonnement, sont respectivement indiqués dans les colonnes "$R_1$" et "$R_4$", et sont égaux à 30/70 pour les cellules n°9 à n°14 et 50/50 pour la cellule n°8. C'est à dire, dans ce dernier cas, que l'irradiance UV constitue 50 % de l'irradiance totale du rayonnement et l'irradiance IR constitue 50 % de l'irradiance totale du rayonnement. L'irradiance totale moyenne $I_{123}$ (où $I_1 = I_2 = I_3 = I_{123}$) du premier rayonnement 310 est de 10 kW/m$^2$ pour les cellules n°9 à n°14 et 38 kW/m$^2$ pour la cellule n°8. L'irradiance totale $I_4$ du deuxième rayonnement est de 50 kW/m$^2$ pour les cellules n°9 à n°14 et 200 kW/m$^2$ pour la cellule n°8.

La première durée d'exposition $d_{123}$ de chaque cellule au premier rayonnement 310 est ici de 10 secondes. La deuxième durée d'exposition $d_4$ de chaque cellule au deuxième rayonnement est de 2 secondes.

Les résultats regroupés dans le [Tableaux3] montrent que la résistance à la rupture est constante et de nature cohésive. La résistance à la rupture est comprise entre 0,7 N/mm et 0,8 N/mm lorsque les cellules 4 ont été exposées 2 secondes au deuxième rayonnement et uniquement 10 s au premier rayonnement 310, quelle que soit l'orientation de la cellule 4. La nature de la rupture est en revanche principalement cohésive. La résistance à la rupture et la nature de la rupture obtenues dans ces conditions opératoires est améliorées par rapport aux résultats du [Tableaux1] et supérieures à des résultats mettant en oeuvre un procédé de durcissement selon l'art antérieur. Les cellules 4 traitées suivant ce mode opératoire font de bonnes candidates pour une interconnexion au sein d'une chaîne photovoltaïque ou pour la réalisation d'un module photovoltaïque. De plus, la durée totale d'exposition, d'environ 12 secondes est nettement inférieure à un temps de traitement selon l'art antérieur, permettant ainsi d'atteindre une cadence de production élevée, compatible avec les exigences industrielles. Les cellules présentent également un gain en rendement de conversion énergétique compris entre 0,2 % et 0,4 % absolu.

[Table 3]

| CEL | $R_4$ | $I_4$ (kW/m$^2$) | $d_4$ (s) | $R_1$ | I123 (kW/m$^2$) | d123 (s) | Orient. | T (N/mm) | Rupture |
|-----|-------|------------------|-----------|-------|------------------|----------|---------|----------|---------|
| 8 | 50/50 | 200 | 2 | 50/50 | 38 | 10 | COL | [0,7 ; 0,8] | C |
| 9 | 30/70 | 50 | 2 | 30/70 | 10 | 10 | COL | [0,7 ; 0,8] | C |
| 10 | 30/70 | 50 | 2 | 30/70 | 10 | 10 | COL | [0,7 ; 0,8] | C + A |
| 11 | 30/70 | 50 | 2 | 30/70 | 10 | 10 | COL | [0,7 ; 0,8] | C |
| 12 | 30/70 | 50 | 2 | 30/70 | 10 | 10 | EM | [0,7 ; 0,8] | C |
| 13 | 30/70 | 50 | 2 | 30/70 | 10 | 10 | EM | [0,7 ; 0,8] | C |
| 14 | 30/70 | 50 | 2 | 30/70 | 10 | 10 | EM | [0,7 ; 0,8] | C |

Les inventeurs ont réalisé des quatrièmes essais, afin de déterminer la température de la portion de pâte 5 en fonction de la première irradiance $I_1$, de la première durée d'exposition $d_1$, de la deuxième irradiance $I_4$ et de la deuxième durée d'exposition $d_4$. Les principaux résultats sont regroupés dans le [Tableaux4] ci-dessous. Les conditions opératoires des quatrièmes essais sont similaires aux deuxièmes essais (décrit en référence au [Tableaux2]) à la différence que le procédé 3 met en oeuvre une deuxième étape d'exposition 32.

Les résultats dans le [Tableaux4] montrent la température en degré Celsius obtenue en fonction de la première irradiance $I_1$, de la première durée d'exposition $d_{123}$, de la deuxième irradiance $I_4$ et de la deuxième durée d'exposition $d_4$. La montée en température de la cellule 4 est plus rapide, elle atteint par exemple la température visée à l'issue de la deuxième durée d'exposition $d_4$. Ainsi, la durée pendant laquelle elle présente une température permettant le durcissement de la pâte conductrice 5 est augmentée.

[Table 4]

| T (°C) | $I_4$ (kW/m$^2$) | $d_4$ (s) | $I_1$ (kW/m$^2$) | $d_1$ (s) |
|--------|------------------|-----------|------------------|-----------|
| 120 | 50 | 0,9 | 4,3 | 29 |
| 140 | 50 | 1 | 6 | 29 |

(suite)

| T (°C) | $I_4$ (kW/m$^2$) | $d_4$ (s) | $I_1$ (kW/m$^2$) | $d_1$ (s) |
|---|---|---|---|---|
| 180 | 50 | 1,2 | 8,5 | 29 |
| 220 | 50 | 1,5 | 11,5 | 29 |

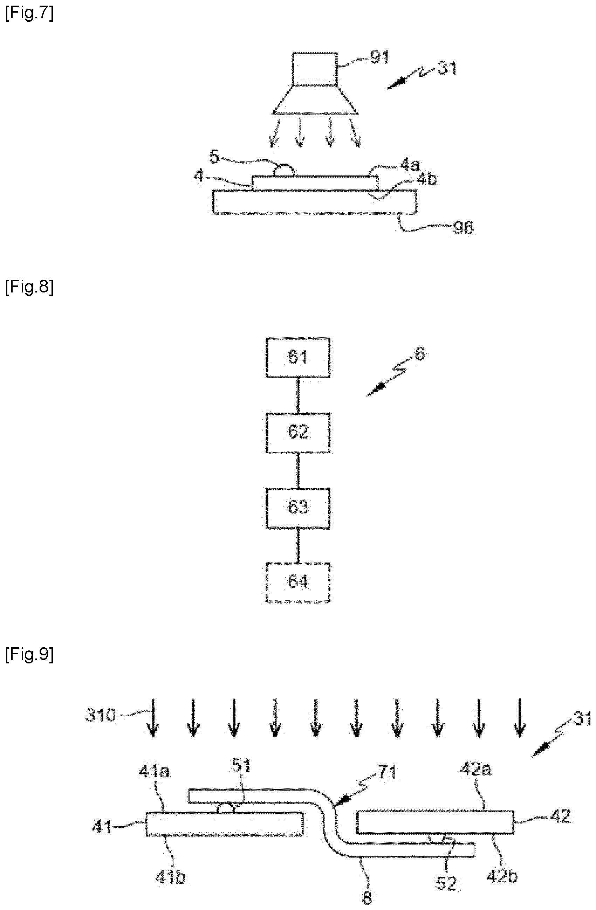

La [FIG.7] représente schématiquement un deuxième mode de mise en oeuvre du procédé de durcissement 3. À la différence du mode de mise en oeuvre de la [FIG.3], la cellule 4 est également chauffée lors de la première étape d'exposition 31 au moyen d'une source de chaleur 96, distincte du premier rayonnement 310. Ainsi, la température de la cellule 4 peut être davantage augmentée.

La source de chaleur 96 est par exemple un support chauffant mis au contact de la deuxième face 4b de la cellule 4. Dans cette configuration, l'apport de chaleur des courtes longueurs d'onde au niveau du voisinage de la première face 4a peut être équilibré par le chauffage de la deuxième face 4b au moyen du support chauffant. Ainsi, le gradient thermique pouvant exister entre les deux faces 4a, 4b peut être réduit, voire complètement annulé.

La cellule 4 peut également être chauffée au moyen d'une source de chaleur 96 lors de la deuxième étape d'exposition 32 et/ou de la troisième étape d'exposition 33. La source de chaleur 96 est préférentiellement différente des premier et deuxième rayonnements 310.

Selon une variante de mise en oeuvre, la cellule 4 est refroidie lors de la première étape d'exposition 31. Elle est par exemple mise en contact thermique avec un dissipateur thermique. Un flux d'air peut également balayer la première face 4a. Les irradiances totales des premier et/ou deuxième rayonnements 310, peuvent ainsi être plus importantes, permettant d'améliorer la bonification, en la rendant par exemple plus rapide, tout en maîtrisant la température de ladite cellule 4.

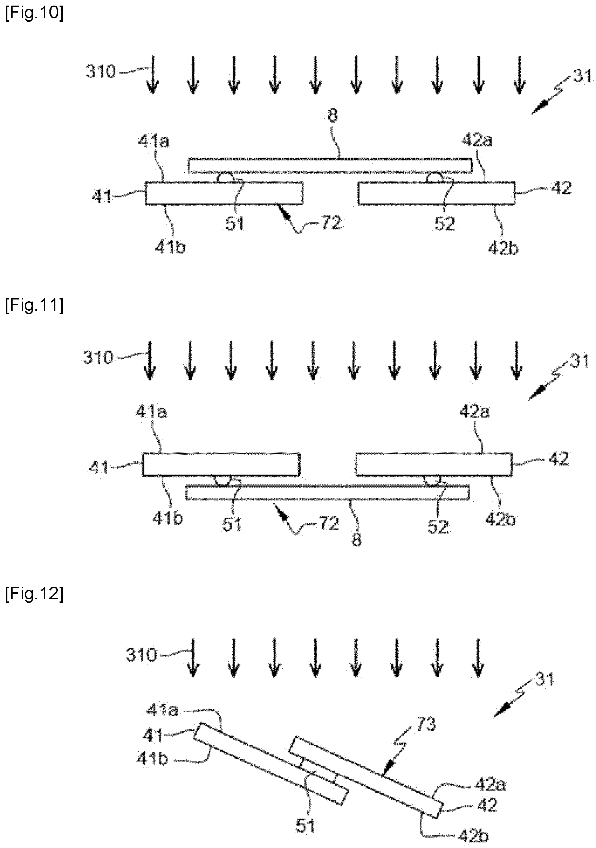

La [FIG.8] représente schématiquement un procédé de fabrication 6 d'une chaîne photovoltaïque 71, 72, 73 à partir d'une première cellule 41 et d'une deuxième cellule 42. Trois types de chaînes photovoltaïques 71, 72, 73 pouvant être obtenues par la mise en oeuvre dudit procédé sont décrites en référence aux [FIG.9], [FIG.10], [FIG.11], [FIG.12].

La [FIG.9] représente un premier mode de mise en oeuvre du procédé de fabrication 6. Chacune des première et deuxième cellules 41, 42 comprend une première face 41a, 42a et une deuxième face 41b, 42b, opposée à la première face 41a, 42a.

Le procédé de fabrication 6 comprend tout d'abord le dépôt 61 d'une première portion de pâte conductrice 51 sur la première face 41a de la première cellule 41. La première portion de pâte conductrice 51 est par exemple sérigraphiée sur la première face 41a. Le procédé de fabrication 6 comprend ensuite l'interconnexion 62 de la deuxième cellule 42 à la première cellule 41. L'interconnexion comprend la mise en contact électrique et mécanique de la deuxième cellule 42 avec la première portion de pâte conductrice 51.

L'interconnexion 62 est par exemple réalisée au moyen d'une deuxième portion de pâte conductrice 52 déposée sur la deuxième faces 42b de la deuxième cellule 42. Un élément d'interconnexion 8, pouvant être un fil conducteur ou un ruban conducteur, est mis en contact de chaque portion de pâte conductrice 51, 52 en étant, par exemple, pressé contre chaque portion de pâte conductrice 51, 52.

Dans ce mode de mise en oeuvre, l'élément d'interconnexion 8 change de plan, passant de la deuxième face 42b de la deuxième cellule 42 à la première face 41a de la première cellule 41. Il s'agit par exemple d'un mode d'interconnexion dit "conventionnel". L'émetteur de chaque cellule 41, 42 est par exemple orienté selon la même direction. L'élément d'interconnexion 8 change donc de plan pour connecter les cellules 41, 42 en série.

Le procédé de fabrication 6 comprend une étape de durcissement 63 de la première portion de pâte conductrice selon le procédé de durcissement 3 décrit précédemment. Plus précisément, le durcissement 63 est au moins réalisé par la première exposition 31 de la première face 41a de la première cellule 41 au premier rayonnement électromagnétique 310.

Le procédé de fabrication peut également comprendre le durcissement de la deuxième portion de pâte conductrice 52. Pour cela, la première face 42a de la deuxième cellule 42 subit avantageusement également au moins la première exposition 31 au premier rayonnement électromagnétique 310. La deuxième cellule 42 peut être exposée en même temps que la première cellule 41, ou à un instant différent.

Grâce à la mise en oeuvre du procédé de durcissement 3, les première et deuxième portions de pâte conductrice 51, 52 peuvent être durcies de manière homogène, quelle que soit la face sur laquelle elles sont disposées. La chaîne photovoltaïque 71 obtenue présente donc une robustesse améliorée. De plus, chaque cellule 41, 42 composant ladite chaîne, exposée au premier rayonnement 310, voit son rendement de conversion énergétique améliorée.

Les premières faces 41a, 42a sont avantageusement orientées vers la source de rayonnement 91. Sur la [FIG.9], les premières faces 41a, 42a des première et deuxième cellule 41, 42 sont agencées dans un même plan et sont orientées dans la même direction, vers le haut de la [FIG.9].

Selon une variante de mise en oeuvre, les premières faces 41a, 42a des première et deuxième cellules 41, 42 ne sont pas agencées dans un même plan. Par exemple la première face 41a de la première cellule 41 peut être orientée vers le haut sur la [FIG.9] et la première face 42a de la deuxième cellule 42 peut être orientée vers le bas sur la [FIG.9]. Auquel cas, la première exposition 31 de chaque première face 41a, 42a est réalisée au moyen de sources de rayonnement différentes, par exemple l'une provenant du haut de la [FIG.9] et l'autre provenant du bas de la [FIG.9]. Les deux sources différentes sont toutefois configurées pour générer le premier rayonnement 310.

La [FIG.10] représente un deuxième mode de mise en oeuvre du procédé de fabrication 6. À la différence du premier mode de mise en oeuvre, décrit en référence à la [FIG.9], la deuxième portion de pâte conductrice 52 est disposée sur la première face 42a de la deuxième cellule 42. Ainsi, l'élément d'interconnexion 8 reste dans le même plan, passant de la première face 42a de la deuxième cellule 42 à la première face 41a de la première cellule 41. Il s'agit par exemple d'un mode d'interconnexion dit "monolithique", permettant de réduire l'espacement entre les cellules 41, 42 interconnectées. Les cellules 41, 42 sont agencées de sorte qu'elles présentent, de manière alternée, leur émetteur ou leur base.

La [FIG.11] représente un troisième mode de mise en oeuvre du procédé de fabrication 6. À la différence du deuxième mode de mise en oeuvre, décrit en référence à la [FIG.10], les première et deuxième portions de pâte conductrice 51, 52 sont disposées sur la deuxième face 41b, 42b des première et deuxième cellules 41, 42. Cette configuration correspond à celle représenté en [FIG. 10] mais retournée. De la même manière, l'élément d'interconnexion 8 reste dans le même plan, passant de la deuxième face 42a de la deuxième cellule 42 à la deuxième face 41b de la première cellule 41. Il s'agit également d'un mode d'interconnexion monolithique.

Grâce à la mise en oeuvre du procédé de durcissement 3, chaque portion de pâte conductrice 51, 52 est durcie de manière optimale.

La [FIG.12] représente un quatrième mode de mise en oeuvre du procédé de fabrication 6. À la différence des premier, deuxième et troisième modes de mise en oeuvre, décrits en référence au [FIG.9], [FIG.10] et [FIG.11], l'interconnexion 62 de la deuxième cellule 42 à la première cellule 41 ne mets pas en oeuvre une deuxième portion de pâte conductrice 52 ou d'élément d'interconnexion 8. L'interconnexion 62 de la deuxième cellule 42 à la première cellule 41 est réalisée en bardeau c'est à dire que les première et deuxième cellule 41, 42 sont superposées les unes sur les autres à la manière de tuiles sur un toit. La deuxième cellule 42 recouvre ainsi la première portion de pâte conductrice 51. La deuxième face 42b de la deuxième cellule 42 est par exemple pressée contre la première portion de pâte conductrice 51. Une zone de la première face 41a de la première cellule 41, dite "zone de recouvrement", est masquée par la deuxième face 42b de la deuxième cellule 42. Ainsi, les première et deuxième cellules 41, 42, sont en contact électrique.

L'exposition 31 des première et deuxième cellule 41, 42 au premier rayonnement 310 permet de chauffer la première portion de pâte conductrice 51 de part et d'autre, améliorant l'homogénéité de son durcissement.

À la différence d'un procédé selon l'art antérieur où le durcissement des portions de pâte conductrice et la bonification des cellules pourraient être réalisées dans deux étapes différentes, le procédé de fabrication 6 permet de combiner ces étapes, réduisant le nombre d'étapes de fabrication.

La réduction du nombre d'étapes de fabrication permet également d'améliorer davantage le rendement de conversion énergétique de chaque cellule. En effet, dans un procédé de fabrication selon l'art antérieur, la bonification des cellules pourrait être réalisée avant la sérigraphie des portions de pâte conductrice. Elle pourrait d'ailleurs être réalisée plusieurs jours avant la sérigraphie. Cela pourrait avoir pour conséquence de retarder l'encapsulation des cellules (lors d'une étape de lamination), réduisant l'effet de la bonification préalablement réalisée et donc de réduire le rendement potentiel de la chaîne photovoltaïque. En effet, un contact prolongé des cellules avec l'air peut avoir pour conséquence de réduire leur rendement de conversion. La réduction observée peut atteindre -0,1% en absolu.

Dans le procédé de fabrication 6, la bonification à lieu après la sérigraphie des portions de pâte conductrice et pendant le durcissement de ces dernières. La chaîne 71, 72, 73 obtenue à l'issue dudit procédé 6 peut ainsi être directement encapsulée lors d'une étape de lamination de manière à former un module photovoltaïque. Il n'est donc pas nécessaire d'ajouter une étape supplémentaire avant de former ledit module. L'instant où la bonification a lieu étant retardé, le délai entre la bonification et l'encapsulation de la chaîne (par exemple lors de la lamination) est réduit. Le risque de réduction de rendement de conversion est donc également réduit.

La [FIG.13] représente schématiquement un mode de réalisation d'un équipement 9 adapté à la mise en oeuvre du procédé de fabrication 6 d'une chaîne photovoltaïque 71, 72, 73 à partir d'une première cellule 41 et d'une deuxième cellule 42.

L'équipement 9 comprend un applicateur 92 pour appliquer la première portion de pâte conductrice 51 sur l'une des faces 41a, 41b de la première cellule 41. L'applicateur 92 permet par exemple de sérigraphier la première portion de pâte conductrice 51. L'applicateur 92 permet avantageusement d'appliquer la deuxième portion de pâte conductrice 52 sur l'une des faces 42a, 42b de la deuxième cellule 42.

L'équipement 9 comprend en outre des moyens 93 pour interconnecter la deuxième cellule 42 avec la première cellule 41. Lesdits moyens 93 permettent par exemple de disposer un élément d'interconnexion 8 entre les première et deuxième portions de pâte conductrice 51, 52 tel que décrit en référence aux [FIG.9], [FIG.10] et [FIG.11]. Lesdits moyens 93 peuvent également agencer les première et deuxième cellules 41, 42 en bardeau, tel que décrit en référence à la [FIG.12]. Les moyens 93 pour interconnecter comprennent par exemple des moyens de découpe pour découper un fil ou un ruban issu d'une bobine de manière à former les éléments d'interconnexion 8 et les agencées avant qu'ils soient interconnectés à l'une des cellules 41, 42. Lesdits moyens 93 peuvent également comprendre un bras mécanique également munis d'une ventouse, permettant de manipuler les cellules 41, 42 et les agencées entre elles et vis-à-vis des éléments d'interconnexion 8. Lesdits moyens 93 peuvent également comprendre un convoyeur également appelé tapis de déplacement, permettant également d'agencée les cellules avec les éléments d'interconnexion 8.

L'équipement 9 est remarquable en ce qu'il comprend également une source de rayonnement 91 pour exposer 31 la première face 41a de la première cellule 41 à un premier rayonnement électromagnétique 310 comprenant au moins une première composante comprise 3100 entre 300 nm et 700 nm. Il s'agit par exemple d'une lampe au xénon. Ladite lampe comporte avantageusement un ou plusieurs filtres transparents au plage UV et IR tels que décrites en référence à la [FIG.5].

La source de rayonnement 91 peut également être configurée pour exposer 31 la première face 41a de la première cellule 41 à un premier rayonnement électromagnétique 310 comprenant au moins une première composante comprise 3100 dans ] 400 nm ; 700 nm ], par exemple entre 410 nm et 700 nm.

La source de rayonnement 91 peut également comprendre un ensemble de diodes électroluminescente ou LED. L'ensemble de LED est par exemple configuré pour émettre au moins une composante entre 300 nm et 700 nm, voire dans ]400 nm ; 700]. L'ensemble de LED peut également comporter un premier sous-ensemble de LED et un deuxième sous-ensemble de LED de manière à émettre un premier rayonnement 310 similaire tel que décrit en référence à la [FIG.5]. Le premier sous-ensemble de LED est par exemple configuré pour émettre une première composante 3101 comprise entre 300 nm et 550 nm tandis que le deuxième sous-ensemble de LED est par exemple configuré pour émettre une deuxième composante 3102 comprise entre 700 nm et 1200 nm et de préférence 800 nm et 1100 nm.

Parce que l'équipement 9 permet de réaliser le durcissement de la première portion de pâte conductrice 51 et la bonification de la première cellule 41, en même temps, il permet de mutualiser la source de rayonnement 91 et peut ainsi présenter un encombrement réduit.

L'équipement 9 peut également être obtenu à partir d'un équipement de fabrication d'une chaîne selon l'art antérieur, tel que décrit en référence à la [FIG.2]. Il suffit pour cela d'ajouter la source de rayonnement 91 à l'équipement selon l'art antérieur, de sorte qu'il puisse exposer la première face 4a d'une première cellule 41 au premier rayonnement 310, ladite première cellule 41 comprenant une première portion de pâte conductrice 51 sur l'une de ses faces 41a, 41b, la première cellule 41 étant interconnectée à une deuxième cellule 42. Ainsi, il est possible de convertir un équipement existant en un équipement 9 selon l'invention permettant d'homogénéiser le durcissement de la pâte conductrice et de bonifier les cellules 41, 42.

L'équipement 9 peut également comprendre une plaque de verre transparente, par exemple un verre synthétique tel que le Plexiglas (TM), transparent aux longueurs d'onde comprises entre 300 nm et 700 et préférentiellement entre 300 nm et 1200 nm. La plaque de verre est par exemple disposée entre la source de rayonnement 91 et les première et deuxième cellules 41, 42 de manière à protéger la source de rayonnement 91 des évaporations ou émanations gazeuses liées aux résidus pouvant émaner des cellules 41, 42 chauffées.

L'équipement 9 peut en outre comprendre une source de chaleur 96, distincte de la source de rayonnement 91. Il peut s'agir d'un support chauffant, tel que présenté en référence à la [FIG.7].

L'équipement 9 peut également comprendre une sonde de température 94 pour déterminer la température de la portion de pâte conductrice 51 pendant l'exposition 31 au premier rayonnement électromagnétique 310.

Enfin, l'équipement 9 peut comprendre un banc d'essai 95 pour déterminer la résistance à la rupture de la première portion de pâte conductrice 51, préférentiellement une fois durcie. Le banc d'essai 95 est par exemple configuré pour appliquer un effort de traction entre les premier et deuxième cellules 41, 42 ou entre la première cellule 41 et l'élément d'interconnexion 8 s'il y a lieu.

## Revendications

1. Procédé de durcissement (3) d'une première portion de pâte conductrice (51) interconnectant une première cellule photovoltaïque (41) à une deuxième cellule photovoltaïque (42), la première portion de pâte conductrice (51) étant disposée sur la première cellule photovoltaïque (41), la première cellule photovoltaïque (41) comprenant une première face (41a) et une deuxième face (41b), opposée à la première face (41a), la première portion de pâte conductrice (51) étant disposée sur l'une des première et deuxième faces (41a, 41b) de la première cellule photovoltaïque (41), la deuxième cellule photovoltaïque (42) étant interconnectée à la première cellule photovoltaïque (41) au moyen de la première portion de pâte conductrice (51), le procédé de durcissement (3) comprenant une première étape d'exposition (31) de la première face (41a) de la première cellule photovoltaïque (41) à un premier rayonnement électromagnétique (310) comprenant une composante (3100) comprise entre 300 nm et 550 nm et une deuxième composante (3102) comprise entre 700 nm et 1200 nm.

2. Procédé de durcissement (3) selon la revendication précédente, dans lequel le premier rayonnement électromagnétique (310) présente une irradiance spectrale entre 550 nm et 700 nm inférieure à 0,04 W/m$^2$/nm.

3. Procédé de durcissement (3) selon l'une des deux revendications précédentes, dans lequel le premier rayonnement électromagnétique (310) présente :

   - une première irradiance, dite irradiance UV, entre 300 nm et 550 nm ; et
   - une deuxième irradiance, dite irradiance IR, entre 700 nm et 1200 nm ; le rapport de l'irradiance UV sur l'irradiance IR étant compris entre 10/90 et 50/50.

4. Procédé de durcissement (3) selon l'une des revendications précédentes, dans lequel la première étape d'exposition (31) présente une première durée d'exposition ($d_{123}$) comprenant une première période ($d_1$), une deuxième période ($d_2$) et une troisième période ($d_3$), séquentielles et consécutives, et dans lequel le premier rayonnement électromagnétique (310) présente :

   - une première irradiance totale ($I_1$) lors de la première période ($d_1$) ;
   - une deuxième irradiance totale ($I_2$) lors de la deuxième période ($d_2$) ; et
   - une troisième irradiance totale ($I_3$) lors de la troisième période ($d_3$) ; et dans lequel les première et deuxième irradiances totales ($I_1$, $I_2$) sont supérieures ou égales à la troisième irradiance totale ($I_3$).

5. Procédé de durcissement (3) selon la revendication 4, dans lequel la durée de la première période ($d_1$) est ajustée de sorte que la température de la première cellule photovoltaïque (41) soit stabilisée à l'issue de la première période ($d_1$) et dans lequel la deuxième irradiance totale ($I_2$) est supérieure à la première irradiance totale ($I_1$).

6. Procédé de durcissement (3) selon l'une des revendications 4 ou 5, comprenant une deuxième étape d'exposition (32) de la première face (41a) de la première cellule photovoltaïque (41) à un deuxième rayonnement électromagnétique, dans lequel la deuxième étape d'exposition (32) est réalisée avant la première étape d'exposition (31), dans lequel le deuxième rayonnement électromagnétique présente une quatrième irradiance totale ($I_4$) supérieure à la première irradiance totale ($I_1$) et dans lequel la deuxième étape d'exposition (32) présente une deuxième durée d'exposition ($d_4$) inférieure à la première durée d'exposition ($d_{123}$).

7. Procédé de durcissement (3) selon la revendication précédente, dans lequel l'intervalle de temps ($d_{123} + d_6 + d_4$) entre le début de la deuxième étape d'exposition (32) et la fin de la première étape d'exposition (31) est inférieur ou égal à 20 s.

8. Procédé de durcissement (3) selon l'une des revendications 4 à 7, comprenant une troisième étape d'exposition (33) de la première face (41a) de la première cellule photovoltaïque (41) à un troisième rayonnement électromagnétique, dans lequel la troisième étape d'exposition (33) est immédiatement consécutive à la première étape d'exposition (31) et dans lequel le troisième rayonnement électromagnétique présente une cinquième irradiance totale décroissante en fonction du temps depuis la troisième irradiance totale ($I_3$).

9. Procédé de durcissement (3) selon l'une des revendications 4 à 8, dans lequel la pâte conductrice (51) est un adhésif électriquement conducteur et dans lequel les première, deuxième et troisième irradiances totales ($I_1$, $I_2$, $I_3$) et la première durée d'exposition ($d_{123}$) sont choisies de sorte que la température de la première cellule photovoltaïque (41) soit comprise entre 150 °C et 250 °C pendant au moins 90% de la première durée d'exposition ($d_1$).

10. Procédé de durcissement (3) selon l'une des revendications 4 à 9, dans lequel la pâte conductrice (51) est une pâte à souder présentant une température de fusion $T_f$, dans lequel la deuxième irradiance totale ($I_2$) est supérieure au première et troisième irradiances totales ($I_1$, $I_3$), et dans lequel les première et troisième irradiances totales ($I_1$, $I_3$) sont choisies de sorte que la température de la cellule photovoltaïque (4) soit comprise dans [$T_f$ - 5°C; $T_f$] pendant au moins 60% des première et troisième périodes ($d_1$, $d_3$) et la deuxième irradiance totale ($I_2$) est choisie de sorte que la température de la première cellule photovoltaïque (41) soit supérieure ou égale à $T_f$ + 10°C pendant au moins 60% de la deuxième période ($d_2$).

**11.** Procédé de durcissement (3) selon l'une des revendications précédentes, dans lequel la première cellule photovoltaïque (41) est :

- chauffée lors de la première étape d'exposition (31), au moyen d'une source de chaleur (96) distincte du premier rayonnement électromagnétique (310) ; ou
- refroidie lors de la première étape d'exposition (31).

**12.** Procédé de fabrication (6) d'une chaîne photovoltaïque (71) à partir d'une première cellule photovoltaïque (41) et d'une deuxième cellule photovoltaïque (42), chacune des première et deuxième cellules photovoltaïques (41, 42) comprenant une première face (41a, 42a) et une deuxième face (41b, 42b), opposée à la première face (41a, 42a), le procédé (6) comprenant les étapes suivantes :

- déposer (61) une première portion de pâte conductrice (51) sur l'une des première et deuxième faces (41a, 41b) de la première cellule photovoltaïque (41) ;
- interconnecter (62) la deuxième cellule photovoltaïque (42) à la première cellule photovoltaïque (41) au moyen de la première portion de pâte conductrice (51) ; et
- durcir (63) la première portion de pâte conductrice (51) interconnectant (62) la deuxième cellule photovoltaïque (42) à la première cellule photovoltaïque (41) au moyen d'un procédé de durcissement (3) selon l'une des revendications précédentes.

**13.** Procédé de fabrication (6) selon la revendication 12, dans lequel la deuxième cellule photovoltaïque (42) recouvre la première portion de pâte conductrice (51).

**14.** Procédé de fabrication (6) selon la revendication 12, dans lequel une deuxième portion de pâte conductrice (52) est disposée sur l'une des première et deuxième faces (42a, 42b) de la deuxième cellule photovoltaïque (42), la deuxième cellule photovoltaïque (42) étant interconnectée à la première cellule (41) au moyen d'un élément d'interconnexion (8) connectant la première portion de pâte conductrice (51) avec la deuxième portion de pâte conductrice (52), le procédé (6) comprenant également le durcissement (64) de la deuxième portion de pâte conductrice (52) au moyen du procédé de durcissement (3) selon l'une des revendications 1 à 11.

**15.** Équipement (9) pour fabriquer une chaîne photovoltaïque (71, 72, 73) à partir d'une première cellule photovoltaïque (41) et d'une deuxième cellule photovoltaïque (42), chacune des cellules photovoltaïques (41, 42) comprenant une première face (41a, 42a) et une deuxième face (41b, 42b), opposée à la première face (41a, 42a), l'équipement (9) comprenant :

- un applicateur (92) configuré pour appliquer une première portion de pâte conductrice (51) sur l'une des premières et deuxièmes faces (41a, 41b) de la première cellule photovoltaïque (41) ;
- des moyens (93) pour interconnecter la deuxième cellule photovoltaïque (42) avec la première cellule photovoltaïque (41) ;

l'équipement (9) étant **caractérisé en ce qu'**il comprend :

- une source de rayonnement (91) configurée pour exposer (31) la première face (41a) de la première cellule photovoltaïque (41) à un premier rayonnement électromagnétique (310) comprenant au moins une première composante comprise (3100) entre 300 nm et 700 nm.

[FIG.1]

[FIG.2]

[Fig.3]

[Fig.4]

[Fig.5]

[Fig.6]

[Fig.7]

[Fig.8]

[Fig.9]

[Fig.10]

[Fig.11]

[Fig.12]

[Fig.13]

**Europäisches Patentamt**
**European Patent Office**
**Office européen des brevets**

# RAPPORT DE RECHERCHE EUROPEENNE

Numéro de la demande

**EP 22 21 4663**

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | US 2018/366596 A1 (CHANG JAEWON [KR] ET AL) 20 décembre 2018 (2018-12-20) | 15 | INV.<br>H01L31/05<br>H01L31/18<br>H01B1/22 |
| A | * le document en entier * <br>----- | 1-14 | |
| X | FR 3 099 294 A1 (COMMISSARIAT ENERGIE ATOMIQUE) 29 janvier 2021 (2021-01-29) | 15 | |
| A | * le document en entier * <br>----- | 1-14 | |
| A | US 2018/138354 A1 (JAFFRENNOU PÉRINE [US] ET AL) 17 mai 2018 (2018-05-17) <br>* le document en entier * <br>----- | 1-15 | |

**DOMAINES TECHNIQUES RECHERCHES (IPC)**

H01L
H05B
H01B

Le présent rapport a été établi pour toutes les revendications

| Lieu de la recherche | Date d'achèvement de la recherche | Examinateur |
|---|---|---|
| Berlin | 29 mars 2023 | Voignier, Vincent |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
.............................................................................
& : membre de la même famille, document correspondant

EPO FORM 1503 03.82 (P04C02)

## ANNEXE AU RAPPORT DE RECHERCHE EUROPEENNE
## RELATIF A LA DEMANDE DE BREVET EUROPEEN NO.

EP 22 21 4663

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

29-03-2023

| Document brevet cité au rapport de recherche | Date de publication | Membre(s) de la famille de brevet(s) | Date de publication |
|---|---|---|---|
| US 2018366596 A1 | 20-12-2018 | EP 3416196 A1 | 19-12-2018 |
| | | JP 2019004135 A | 10-01-2019 |
| | | KR 20180136278 A | 24-12-2018 |
| | | US 2018366596 A1 | 20-12-2018 |
| FR 3099294 A1 | 29-01-2021 | CN 114503289 A | 13-05-2022 |
| | | EP 4004986 A1 | 01-06-2022 |
| | | FR 3099294 A1 | 29-01-2021 |
| | | US 2022246774 A1 | 04-08-2022 |
| | | WO 2021018757 A1 | 04-02-2021 |
| US 2018138354 A1 | 17-05-2018 | CN 108075012 A | 25-05-2018 |
| | | US 2018138354 A1 | 17-05-2018 |

EPO FORM P0460

Pour tout renseignement concernant cette annexe : voir Journal Officiel de l'Office européen des brevets, No.12/82